# EUROPEAN PATENT APPLICATION

(11) **EP 4 776 817 A1**
(43) Date of publication of application: **15.07.2026**
(21) Application number: 25804564.0
(22) Date of filing: 04.11.2025
(51) Int. Cl.: H10K 77/10, G09F 9/30, H10K 59/80, H10K 59/90

(54) **ELECTRONIC DEVICE INCLUDING FLEXIBLE DISPLAY**

(30) Priority: 06.11.2024 KR 20240156108; 24.01.2025 KR 20250011123
(71) Applicant: SAMSUNG ELECTRONICS CO., LTD., Yeongtong-gu Suwon-si, Gyeonggi-do 16677 (KR)
(72) Inventor: AHN, Sungho, Suwon-si, Gyeonggi-do 16677 (KR); WOO, Sunggwan, Suwon-si, Gyeonggi-do 16677 (KR); LEE, Jungwoo, Suwon-si, Gyeonggi-do 16677 (KR)
(74) Representative: Gulde & Partner
(86) International application number: PCT/KR2025/017913
(87) International publication number: WO 2026/101175

(57) **Abstract**

Embodiments of the disclosure relate to an electronic device including a flexible display. The electronic device may include a first housing, a second housing movably coupled to the first housing so as to allow the electronic device to transition between a slide-in state and a slide-out state, and a flexible display. The flexible display may include a display area, a first non-display area extending from the display area in a first direction, the first direction being a direction in which the flexible display moves when the electronic device transitions from the slide-out state to the slide-in state, and a second non-display area extending from the first non-display area in the first direction. The first non-display area may be an area in which a thin-film encapsulation layer having a structure in which an organic layer is disposed between two inorganic layers is formed, and the second non-display area may be an area in which a thin-film encapsulation layer having a structure in which the two inorganic layers are laminated is formed. The second non-display area may be positioned so as not to be included in the bending portion in any state of the electronic device.

## Description

### [Technical Field]

Embodiments of the disclosure relate to an electronic device including a flexible display.

### [Background Art]

Electronic devices are gradually becoming slimmer and more rigid, being enhanced in design aspects, and being improved to differentiate functional elements thereof. Electronic devices are gradually evolving from a uniform rectangular shape to diverse shapes. An electronic device may have a transformable structure that is convenient to carry and enables the use of a large-screen display. The electronic device may include a rollable electronic device (e.g., a slidable electronic device) capable of varying the display area of a flexible display (e.g., a rollable display) through the support of housings that operate in a sliding manner relative to each other.

The above-described information may be provided as related art for the purpose of helping to understand the disclosure. No claim or determination is made regarding whether any of the foregoing may be applied as prior art with respect to the disclosure.

### [Disclosure of Invention]

### [Technical Problem]

An electronic device may include a rollable electronic device (e.g., a slidable electronic device) capable of inducing expansion and/or contraction of a flexible display's display area (e.g., a rollable display, expandable display, or stretchable display), depending on the operating state. A rollable electronic device may include a first housing and a second housing that are movably coupled to each other. For example, the first housing and the second housing may be configured to slide relative to each other and support at least a portion of a flexible display. The flexible display may be guided to have a first display area in a slide-in state, and may be guided to have a second display area larger than the first display area in a slide-out state.

A portion of the flexible display of the electronic device may be bent with a predetermined curvature when the display area is expanded or reduced, and the stress applied to the portion may cause damage to the flexible display. For example, at least a portion of the flexible display may experience interlayer peel-off due to stress during bending. The interlayer peel-off may refer to a phenomenon in which some of the layers (e.g., a thin film encapsulation layer) included in the flexible display become peeled off.

Embodiments of the disclosure may provide an electronic device including a flexible display that is resistant to stress during bending and capable of reducing interlayer peel-off.

The technical problems to be addressed by this disclosure are not limited to those described above, and other technical problems not mentioned above may be clearly understood by a person ordinarily skilled in the related art to which the disclosure pertains.

### [Solution to Problem]

According to an embodiment of the disclosure, an electronic device may include a first housing, a second housing movably coupled to the first housing so as to allow the electronic device to transition between a slide-in state and a slide-out state, and a flexible display disposed in the first housing and the second housing and including a bending portion configured to move in response to movement of the second housing and to be bent with a predetermined curvature radius.

The flexible display may include a display area in which a plurality of pixels are activated, a first non-display area extending from the display area in a first direction, the first direction being a direction in which the flexible display moves when the electronic device transitions from the slide-out state to the slide-in state, and a second non-display area extending from the first non-display area in the first direction.

The first non-display area may be an area in which a thin-film encapsulation layer having a structure in which an organic layer is disposed between two inorganic layers is formed, and the second non-display area may be an area in which a thin-film encapsulation layer having a structure in which the two inorganic layers are laminated is formed.

The position of the bending portion on the flexible display may change according to a state transition of the electronic device, and the second non-display area may be positioned so as not to be included in the bending portion in any state of the electronic device.

According to an embodiment, an electronic device may include a first housing, a second housing movably coupled to the first housing so as to allow the electronic device to transition between a slide-in state and a slide-out state, and a flexible display including an upper end portion fixed to at least a portion of the first housing, and a lower end portion configured to move inside the second housing in response to movement of the second housing.

The lower end portion of the flexible display may include a first area including a pixel array, a second area including a first inorganic layer, a second inorganic layer, and an organic layer positioned between the first inorganic layer and the second inorganic layer, and a third area including the first inorganic layer, the second inorganic layer, and a dam positioned below the first inorganic layer and the second inorganic layer.

In the slide-in state, at least a portion of the first area may be disposed in a bent state.

In the slide-out state, at least a portion of the second area may be disposed in a bent state.

### [Advantageous Effects of invention]

Embodiments of the disclosure may provide an electronic device including a flexible display that is resistant to stress during bending and capable of reducing interlayer peel-off.

### [Brief Description of Drawings]

Other aspects, features, and advantages according to specific embodiments of the disclosure will become more apparent from the accompanying drawings and the corresponding description.
FIG. 1 is a block diagram of an electronic device according to an embodiment in a network environment.
FIGS. 2A and 2B illustrate front and rear views of an electronic device according to various embodiments of the disclosure in a slide-in state.
FIGS. 3A and 3B illustrate front and rear views of the electronic device according to various embodiments of the disclosure in a slide-out state.
FIG. 4 is an exploded perspective view of an electronic device according to various embodiments of the disclosure.
FIG. 5A is a cross-sectional view of the electronic device according to various embodiments of the disclosure taken along line 5a-5a in FIG. 2A.
FIG. 5B is a cross-sectional view of the electronic device according to various embodiments of the disclosure taken along line 5b-5b in FIG. 3A.
FIG. 6 is a schematic cross-sectional view of a flexible display according to an embodiment of the disclosure.
FIG. 7 is a plan view of a flexible display according to an embodiment of the disclosure.
FIG. 8 is a cross-sectional view of a flexible display in a slide-out state, according to various embodiments of the disclosure.
FIG. 9 is a plan view of a flexible display in which the arrangement of a thin-film encapsulation layer is expanded, according to an embodiment.
FIG. 10 is a cross-sectional view of a flexible display in a slide-in state, according to various embodiments of the disclosure.
FIG. 11 is a cross-sectional view of a flexible display in a slide-out state, according to various embodiments of the disclosure.
FIG. 12 is a cross-sectional view of the flexible display taken along line A-A' of FIG. 9, according to various embodiments of the disclosure.
FIG. 13 is a plan view of a flexible display according to an embodiment of the disclosure.
FIG. 14 is a cross-sectional view of the flexible display taken along line A-A' of FIG. 13, according to various embodiments of the disclosure.
FIG. 15 is a cross-sectional view of the flexible display taken along line B-B' of FIG. 13, according to various embodiments of the disclosure.
FIGS. 16 to 18 are cross-sectional views illustrating cross-sectional shapes of dams according to various embodiments.
FIG. 19 is a cross-sectional view of the flexible display illustrating the dams of FIG. 13, according to various embodiments of the disclosure.
FIG. 20 is a cross-sectional view of a flexible display including a peel-off prevention dam according to an embodiment.
FIG. 21 is a cross-sectional view of a flexible display including a crack prevention dam according to an embodiment.
FIG. 22 is a plan view of a flexible display according to an embodiment of the disclosure.
FIG. 23 is a cross-sectional view of the flexible display taken along line A-A' of FIG. 22, according to various embodiments of the disclosure.
FIG. 24 is a plan view illustrating a wiring structure of a flexible display according to an embodiment of the disclosure.
FIG. 25 is a plan view illustrating an example in which the wiring structure of a flexible display is modified according to an embodiment.
FIG. 26 is a schematic view of an electronic device in a slide-in state according to an embodiment.
FIG. 27 is a schematic view of the electronic device in a slide-out state according to an embodiment.
FIG. 28 is a plan view of the flexible display illustrated in FIG. 26 and/or FIG. 27.

### [Mode for the Invention]

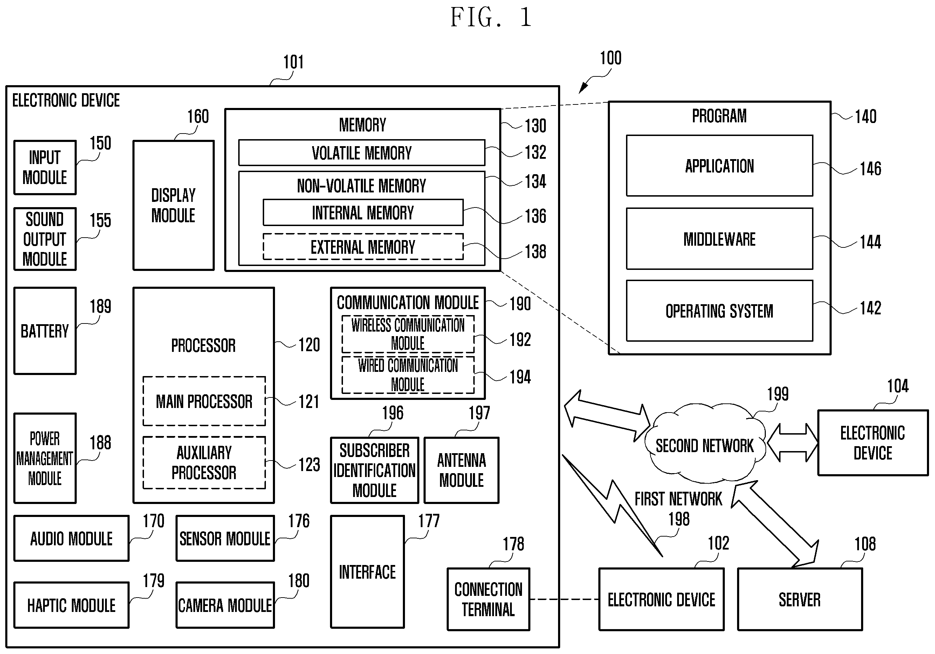

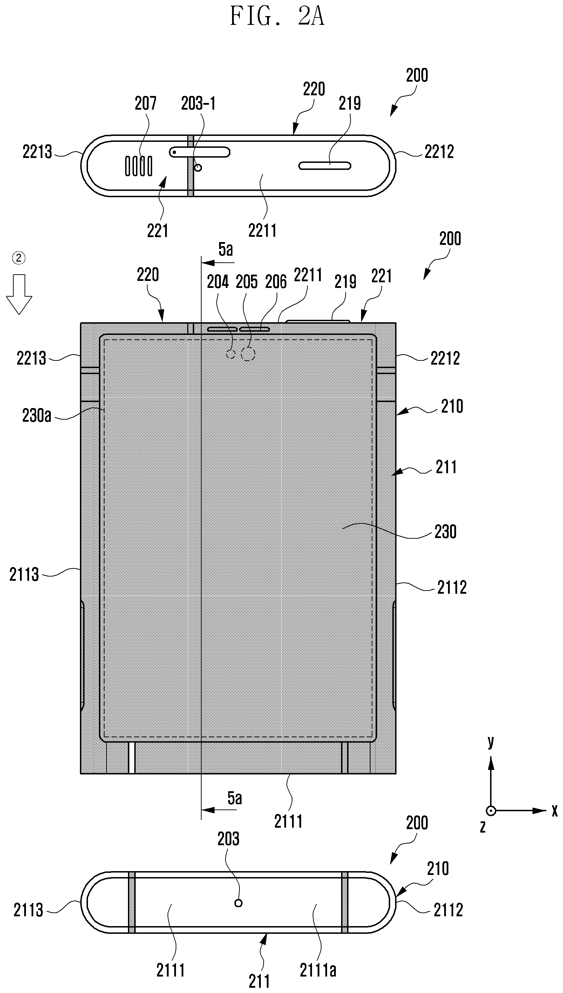

Each of the embodiments described with reference to the drawings of the disclosure may be independently configured as a single embodiment. For example, the embodiment of FIG. 1 and the embodiment of FIG. 2A may be configured independently of each other. Each of the embodiments described with reference to the drawings of the disclosure may operate independently as a single embodiment. For example, the embodiment of FIG. 1 and the embodiment of FIG. 2A may operate independently of each other.

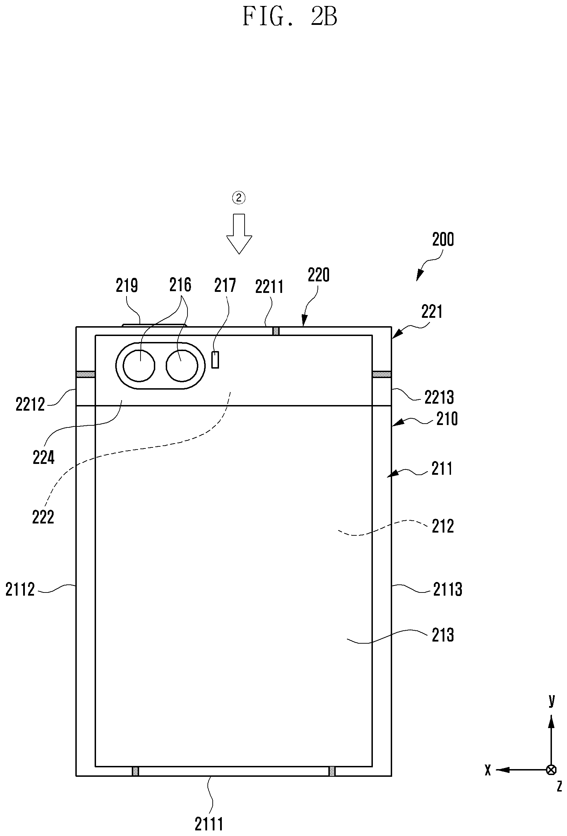

At least two of the embodiments described with reference to the drawings of the disclosure may be combined and configured together. For example, at least a portion of the embodiment of FIG. 1 and at least a portion of the embodiment of FIG. 2 may be combined and configured with each other. At least two of the embodiments described with reference to the drawings of the disclosure may be combined to operate together. For example, at least a portion of the embodiment of FIG. 1 and at least a portion of the embodiment of FIG. 2 may be combined to operate together.

When at least two of the embodiments described with reference to the drawings of the disclosure are combined, at least some components and/or at least some operations included in each embodiment may be omitted. For example, when the embodiment of FIG. 1 and the embodiment of FIG. 2A are combined, at least some components and/or at least some operations included in the embodiment of FIG. 1 may be omitted, and at least some components and/or at least some operations included in the embodiment of FIG. 2A may be omitted.

Fig. 1 is a block diagram illustrating an electronic device 101 in a network environment 100 according to various embodiments. Referring to Fig. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStoreTM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

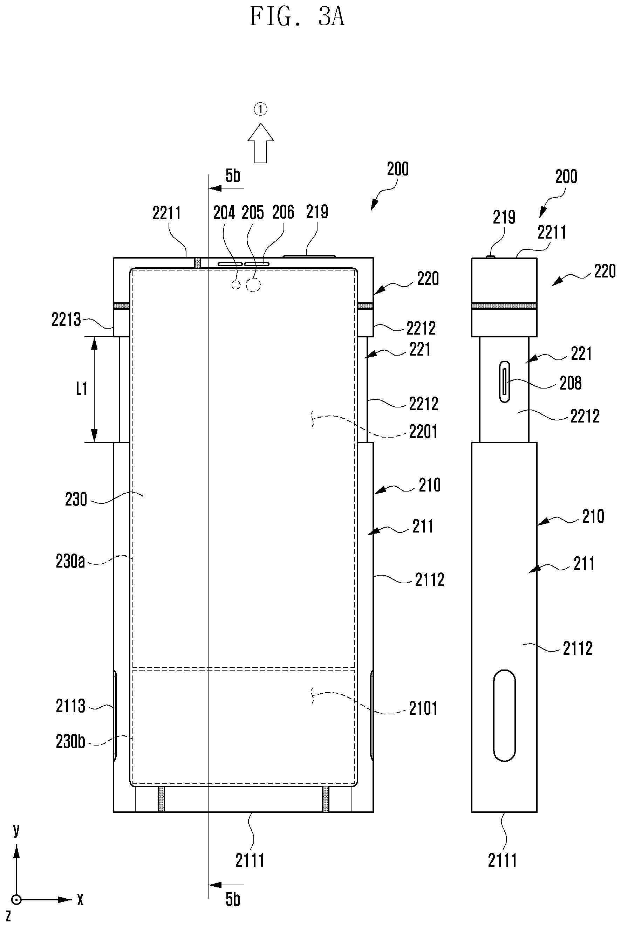

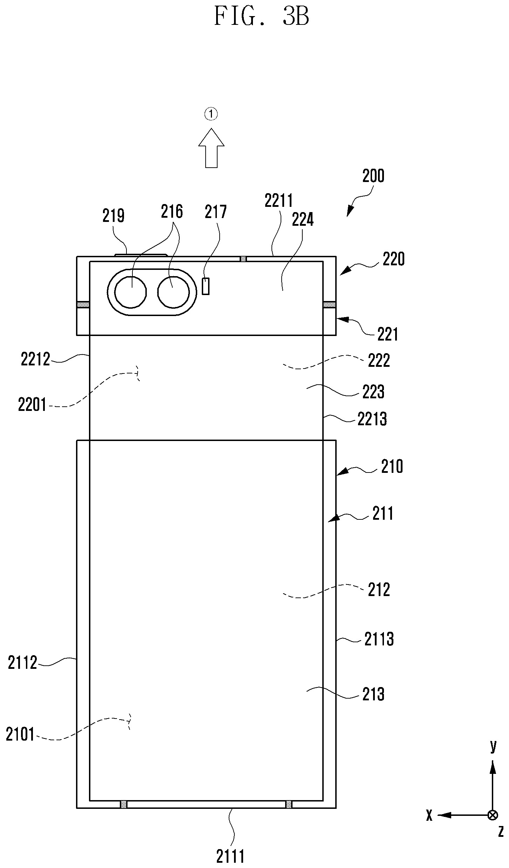

FIGS. 2A and 2B illustrate front and rear views of an electronic device according to various embodiments of the disclosure in a slide-in state. FIGS. 3A and 3B illustrate front and rear views of the electronic device according to various embodiments of the disclosure in a slide-out state.

The electronic device 200 of FIGS. 2A to 3B may be at least partially similar to the electronic device 101 of FIG. 1 or may further include various embodiments of the electronic device.

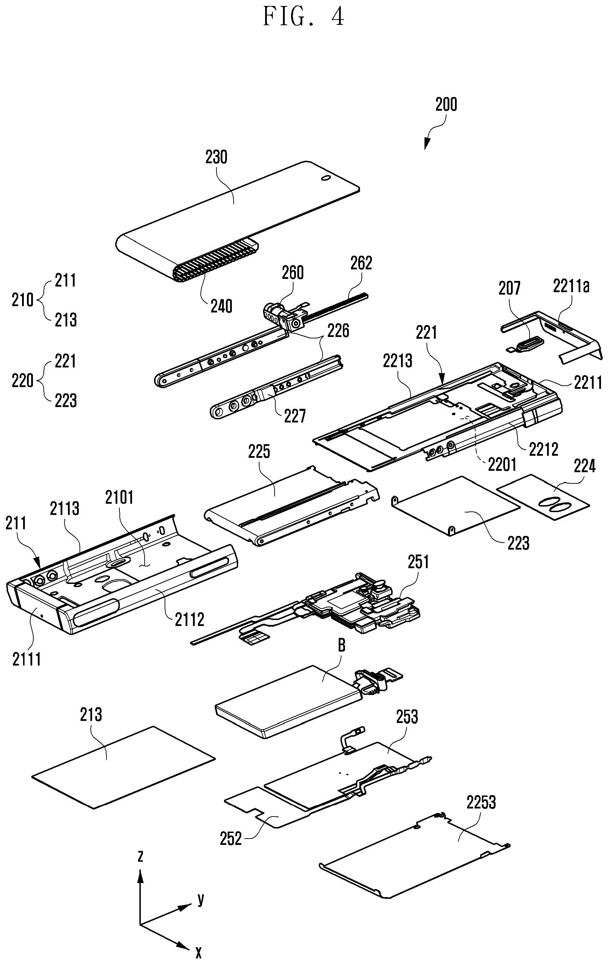

Referring to FIGS. 2A to 3B, an electronic device 200 may include a first housing 210 (e.g., a book cover or a first housing structure), a second housing 220 (e.g., a front cover or a second housing structure) slidably coupled to the first housing 210 in a predetermined direction (e.g., direction ① or direction ②) (e.g., ± y-axis direction), and a flexible display 230 (e.g., a rollable display, an expandable display, or a stretchable display) disposed to be supported by at least a portion of the first housing 210 and the second housing 220. In an embodiment, the second housing 220 may be slidably coupled to the first housing 210 so as to be slid out along a first direction (direction ①) with respect to the first housing 210 or slid in along a second direction (direction ②), which is opposite to the first direction (direction ①). In an embodiment, the electronic device 200 may transition to the first state, which is the slide-in state, as at least a portion of the second housing 220 is accommodated in at least a portion of a first space 2101 formed through the first housing 210. In an embodiment, the electronic device 200 may transition to the second state, which is the slide-out state, as at least a portion of the second housing 220 moves outward (e.g., in direction ①) from the first space 2101. In an embodiment, in the slide-out state, the electronic device 200 may include a support member (e.g., the support member 240 in FIG. 4) (e.g., a bendable member, a multi-joint hinge module, a multi-bar assembly, a support bar assembly, or multiple bars), which at least partially forms substantially the same plane as at least a portion of the second housing 220, and in the slide-in state, is at least partially accommodated in the first space 2101 of the first housing 210 in a bending manner. In an embodiment, at least a portion of the flexible display 230 may be disposed to be supported by at least a portion of the second housing 220. In an embodiment, the remaining portion of the flexible display 230 may be disposed to be at least partially supported by the support member 240 (e.g., the support member 240 in FIG. 4). In an embodiment, the support member (e.g., the support member 240 in FIG. 4) may be disposed in a manner of being attached to the rear surface of the flexible display 230. In an embodiment, in the slide-in state, at least a portion of the flexible display 230 may be accommodated into the first space 2101 of the first housing 210 in a bending manner while being supported by the support member (e.g., the support member 240 in FIG. 4), thereby being disposed to be invisible from the outside. In an embodiment, in the slide-out state, at least a portion of the flexible display 230 may be disposed to be visible from the outside while being supported by the support member (e.g., the support member 240 in FIG. 4A), which at least partially forms the same plane as the second housing 220.

According to various embodiments, the first housing 210 may include a first side surface member 211, and the second housing 220 may include a second side surface member 221. In an embodiment, the first side surface member 211 may be disposed at the bottom side of the electronic device 200 and may include a first side surface 2111 having a first length, a second side surface 2112 extending in a perpendicular direction (e.g., the y-axis direction) from one end of the first side surface 2111 and having a second length, and a third side surface 2113 extending parallel to the second side surface 2112 from the other end of the first side surface 2111 and having the second length. In an embodiment, the first side surface member 211 may be at least partially made of a conductive member (e.g., metal). In some embodiments, the first side surface member 211 may be formed by a coupling a conductive member and a non-conductive member (e.g., polymer). In an embodiment, the first housing 210 may include a first extension member 212 extending from at least a portion of the first side surface member 211 to at least a portion of the first space 2101. In an embodiment, the first extension member 212 may be integrated with the first side surface member 211. In some embodiments, the first extension member 212 may be provided separately from the first side surface member 211 and structurally coupled to the first side surface member 211.

According to various embodiments, the second side surface member 221 may be disposed at the upper side of the electronic device 200 and may include a fourth side surface 2211 having a third length, a fifth side surface 2212 extending in a perpendicular direction (e.g., the -y-axis direction) from one end of the fourth side 2211 to correspond to the second side surface 2112 and having a fourth length, and a sixth side surface 2213 extending in a direction parallel to the fifth side surface 2212 from the other end of the fourth side 2211 to correspond to the third side surface 2113 and having the fourth length. In an embodiment, the second side surface member 221 may be at least partially made of a conductive member (e.g., metal). In some embodiments, the second side surface member 221 may be formed by coupling a conductive member and a non-conductive member (e.g., polymer). In an embodiment, at least a portion of the second side surface member 221 may include a second extension member 222 extending to at least a portion of a second space 2201 in the second housing 220. In an embodiment, the second extension member 222 may be integrated with the second side surface member 221. In some embodiments, the second extension member 222 may be provided separately from the second side surface member 221 and structurally coupled to the second side surface member 221.

According to various embodiments, the second side surface 2112 and the fifth side surface 2212 may be slidably coupled to each other. In an embodiment, the third side surface 2113 and the sixth side surface 2213 may be slidably coupled to each other. In an embodiment, in the slide-in state, a portion of the fifth side surface 2212 may overlap the second side surface 2112, thereby being disposed to be substantially invisible from the outside. In an embodiment, in the slide-in state, the remaining portion of the fifth side surface 2212 may be disposed to be visible from the outside. In some embodiments, in the slide-in state, the fifth side surface 2212 may overlap the second side surface 2112, thereby being disposed to be substantially invisible from the outside. In an embodiment, in the slide-in state, a portion of the sixth side surface 2213 may overlap the third side surface 2113, thereby being disposed to be substantially invisible from the outside. In an embodiment, in the slide-in state, the remaining portion of the sixth side surface 2213 may be disposed to be visible from the outside. In some embodiments, in the slide-in state, the sixth side surface 2213 may overlap the third side surface 2113, thereby being disposed to be substantially invisible from the outside. In an embodiment, a portion of the second extension member 222 may be disposed to be visible from the outside in the slide-in state. In some embodiments, in the slide-in state, the second extension member 222 may overlap the first extension member 212, thereby being disposed to be substantially invisible from the outside.

According to various embodiments, the first housing 210 may include a first rear surface cover 213 coupled to at least a portion of the first side surface member 211. In an embodiment, the first rear surface cover 213 may be disposed to be coupled to at least a portion of the first extension member 212. In some embodiments, the first rear cover 213 may be integrated with the first side surface member 211. In an embodiment, the first rear cover 213 may be made of a polymer, coated or colored glass, ceramic, metal (e.g., aluminum, stainless steel (STS), or magnesium), or a combination of at least two of these materials. In some embodiments, the first rear surface cover 213 may extend to at least a portion of the first side surface member 211. In some embodiments, the first rear surface cover 213 may be omitted, and at least a portion of the first extension member 212 may replace the first rear surface cover 213.

According to various embodiments, the second housing 220 may include a second rear surface cover 223 coupled to at least a portion of the second side surface member 221. In an embodiment, the second rear surface cover 223 may be disposed by being coupled to at least a portion of the second extension member 222. In an embodiment, the second rear surface cover 223 may be integrated with the second side surface member 221. In an embodiment, the second rear surface cover 223 may be made of polymer, coated or tinted glass, ceramic, metal (e.g., aluminum, stainless steel (STS), or magnesium), or a combination of at least two of these materials. In some embodiments, the second rear surface cover 223 may extend to at least a portion of the second side surface member 221. In some embodiments, the second rear surface cover 223 may be omitted, and at least a portion of the second extension member 222 may replace the second rear surface cover 223. In some embodiments, the second extension member 222 may be omitted, and the second rear surface cover 223 may replace the second extension member 222. In an embodiment, the second housing 220 may include a window cover 224 disposed at least partially on the second rear surface cover. In an embodiment, the window cover 224 may be disposed in an area exposed to the outside of the second housing 220 in the slide-in state and may be made of a material that facilitates the detection of the external environment through at least one camera module 216 and/or sensor module 217 disposed in the internal space 2201 of the second housing 220. For example, the window cover 224 may be made of glass and/or a polymer material in which at least an area corresponding to the camera module 216 and/or the sensor module 217 is formed to be transparent. In some embodiments, the electronic device 200 may further include a cover member 2111a disposed to cover at least a portion of the first side surface 2111 of the first housing 210.

According to various embodiments, the flexible display 230 may include a first portion 230a (e.g., a flat portion) that is always visible from the outside, and a second portion 230b (e.g., a bendable portion or a bending portion) that extends from the first portion 230a and is at least partially bent and accommodated into the first space 2101 of the first housing 210 to be invisible from the outside in the slide-in state. In an embodiment, at least a portion of the first portion 230a may be disposed to be supported by the second housing 220, and the remaining portion of the first portion 230a and the second portion 230b may be disposed to be at least partially supported by a support member (e.g., the support member 240 in FIG. 4). In an embodiment, in the state in which the second housing 220 is slid out along the first direction (direction ①), the second portion 230b of the flexible display 230 may form substantially the same plane as the first portion 230a while being supported by the support member (e.g., the support member 240 in FIG. 4), and may be disposed to be visible from the outside. In an embodiment, in the state in which the second housing 220 is slid in along the second direction (direction ②), the second portion 230b of the flexible display 230 may be accommodated into the first space 2101 of the first housing 210 in a bending manner and may be disposed to be invisible from the outside. Accordingly, the display area of the flexible display 230 may be variable as the second housing 220 is moved in a sliding manner from the first housing 210 along a predetermined direction (e.g., the ±y-axis direction).

According to various embodiments, the flexible display 230 may have a first display area (e.g., an area corresponding to the first portion 230a) in the slide-in state (e.g., the first state). In an embodiment, when the second housing 220 transitions to the slide-out state (e.g., the second state), in which the second housing 220 moves by a first length L1 (e.g., a sliding stroke) relative to the first housing 210, in the flexible display 230, a second display area (e.g., an area corresponding to the second portion 230b) corresponding to the first length L1 may be additionally secured in addition to the first display area. For example, when the flexible display 230 transitions from the slide-in state to the slide-out state, the display area may be expanded.

According to various embodiments, the electronic device 200 may include at least one of an input device (e.g., a microphone 203-1) disposed in the second space 2201 of the second housing 220, a sound output device (e.g., a phone call receiver 206 and/or a speaker 207), sensor modules 204 and 217, a camera module (e.g., the first camera module 205 or the second camera module 216), a connector port 208, a key input device 219, or an indicator (not illustrated). In an embodiment, the electronic device 200 may include another input device (e.g., the microphone 203) disposed in the first housing 210. In some embodiments, the electronic device 200 may be configured such that at least one of the above-mentioned components is omitted or other components are additionally included. In some embodiments, at least one of the above-mentioned components may be disposed in the first space 2101 of the first housing 210.

According to various embodiments, the input device may include a microphone 203-1. In some embodiments, the input device (e.g., the microphone 203-1) may include a plurality of microphones arranged to detect the direction of sound. The sound output device may include, for example, a call receiver 206 and a speaker 207. According to an embodiment, regardless of the slide-in/slide-out state, the speaker 207 may face the outside through at least one speaker hole provided in the second housing 220 at a position always exposed to the outside (e.g., in the fourth side surface 2211). In an embodiment, in the slide-out state, the connector port 208 may face the outside through a connector port hole provided in the second housing 220. In an embodiment, the connector port 208 may be covered so as to be invisible from the outside in the slide-in state. In some embodiments, in the slide-in state, the connector port 208 may face the outside through an opening provided in the first housing 210 to correspond to the connector port hole. In some embodiments, the call receiver 206 may include a speaker that operates without a separate speaker hole (e.g., a piezo speaker).

According to various embodiments, the sensor modules 204 and 217 may generate electrical signals or data values corresponding to an internal operating state or an external environmental state of the electronic device 200. In an embodiment, the sensor modules 204 and 217 may include, for example, a first sensor module 204 (e.g., a proximity sensor or an illuminance sensor) disposed on the front surface of the electronic device 200 and/or a second sensor module 217 (e.g., a heart rate monitoring (HRM) sensor) disposed on the rear surface of the electronic device 200. In an embodiment, the first sensor module 204 may be disposed under the flexible display 230 in the front surface of the electronic device 200. In an embodiment, the first sensor module 204 and/or the second sensor module 217 may include at least one of a proximity sensor, an illuminance sensor, a time-of-flight (TOF) sensor, an ultrasonic sensor, a fingerprint recognition sensor, a gesture sensor, a gyro sensor, an atmospheric pressure sensor, a magnetic sensor, an acceleration sensor, a grip sensor, a color sensor, an infrared (IR) sensor, a biometric sensor, a temperature sensor, or a humidity sensor.

According to various embodiments, the camera module may include a first camera module 205 disposed on the front surface of the electronic device 200 and a second camera module 216 disposed on the rear surface of the electronic device 200. In an embodiment, the electronic device 200 may include a flash (not illustrated) positioned near the second camera module 216. In an embodiment, the camera modules 205 and 216 may include one or more lenses, an image sensor, and/or an image signal processor. In an embodiment, the first camera module 205 may be disposed under the flexible display 230 and may be configured to capture a subject through a portion of an active area (e.g., a display area) of the flexible display 230.

According to various embodiments, the first camera module 205 among the camera modules and the first sensor module 204 among the sensor modules 204 and 217 may be disposed to detect the external environment through the flexible display 230. For example, the first camera module 205 or the first sensor module 204 may be disposed in the second space 2201 in the second housing 220 to be in contact with the external environment through a transmissive area or a perforated opening provided in the flexible display 230. In an embodiment, the area of the flexible display 230 that faces the first camera module 205 may be configured as the transmissive area having a predetermined transmittance, as a portion of an active area that displays content. In an embodiment, the transmissive area may have a transmittance ranging from about 5% to about 20%. The transmission area may include an area overlapping an effective area (e.g., a field of view area) of the first camera module 205 through which light imaged by an image sensor to generate an image passes. For example, the transmissive area of the flexible display 230 may include an area having a lower pixel density and/or a lower wire density than the surrounding area. For example, the above-mentioned opening may replace the transmissive area. For example, some camera modules (e.g., the first camera module 205) may include an under-display camera (UDC). In some embodiments, some sensor modules 204 may be disposed to perform the functions thereof in the second space 2201 in the second housing 220 without being visually exposed through the flexible display 230.

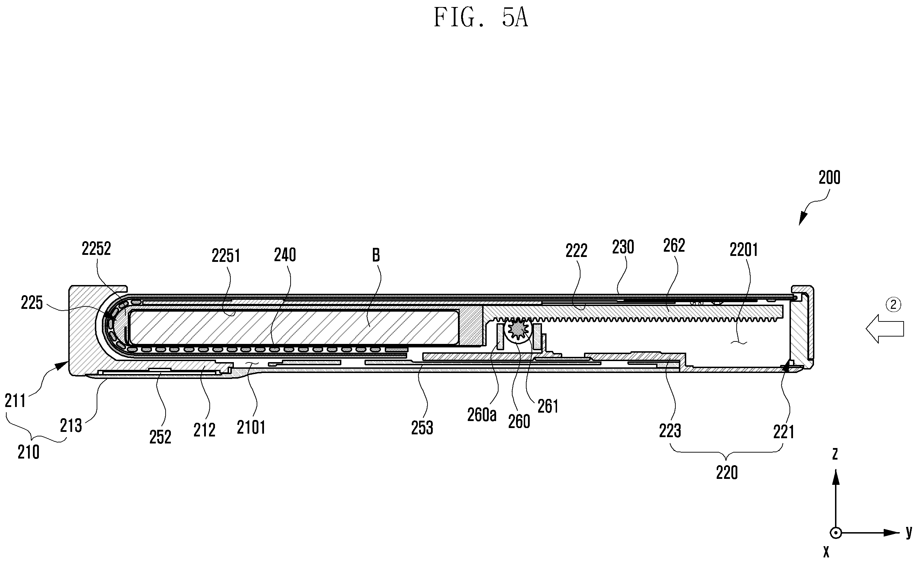

According to various embodiments, the slide-in operation and/or slide-out operation of the electronic device 200 may be automatically performed. For example, the slide-in operation and/or slide-out operation of the electronic device 200 may be performed through gear engagement between a drive motor (e.g., the drive motor 260 in FIG. 4), which includes a pinion gear (e.g., the pinion gear 261 in FIG. 5A) disposed in the second space 2201 of the second housing 220, and a rack gear (e.g., the rack gear 262 in FIG. 5A), which is disposed in a first space 2101 of the first housing 210, extends at least partially into the second space 2201, and is engaged with the pinion gear (e.g., the pinion gear 261 of FIG. 5A). For example, the processor (e.g., the processor 120 in FIG. 1) of the electronic device 200 may drive a drive motor (e.g., the drive motor 260 of FIG. 4) disposed inside the electronic device 200 when detecting a triggering signal for transitioning from the slide-in state to the slide-out state or from the slide-out state to the slide-in state. In an embodiment, the triggering signal may include a signal generated by the selection (e.g., touch) of an object displayed on the flexible display 230 or a signal generated by the operation (e.g., pressing) of a physical button (e.g., a key button) included in the electronic device 200.

According to various embodiments, the electronic device 200 has a structure in which the second housing 220 is slid in and/or slid out with respect to the first housing 210 along the length direction of the electronic device 200 (e.g., the vertical direction) (e.g., the ±y-axis direction), but is not limited thereto. For example, the electronic device 200 may have a structure in which the second housing 220 is slid in and/or slid out with respect to the first housing 210 along the width direction perpendicular to the length direction of the electronic device 200 (e.g., the horizontal direction) (e.g., the ±x-axis direction). In some embodiments, in the electronic device 200, the length of the first side surface 2111 of the first housing 210 may be greater than the length of the second side surface 2112. In this case, correspondingly, the length of the fourth side surface 2211 of the second housing 220 may also be greater than the length of the fifth side surface 2212.

FIG. 4 is an exploded perspective view of an electronic device according to various embodiments of the disclosure.

In describing the electronic device 200 of FIG. 4, components that are substantially the same as those of the electronic device 200 of FIGS. 2A to 3B may be assigned with the same reference numerals, and a detailed description thereof may be omitted.

Referring to FIG. 4, the electronic device 200 may include a first housing 210 including a first space 2101, a second housing 220 slidably coupled to the first housing 210 and including a second space 2201, a support member 240 (e.g., a bendable member, a support bar assembly, or a multi-bar assembly) fixed to at least a portion of the second housing 220 and at least partially accommodated in the first space 2101 in a bendable manner according to the slide-in operation, a flexible display 230 disposed to be supported by at least a portion of the support member 240 and the second housing 220, and a driver (e.g., a drive module or a drive mechanism) configured to drive the second housing 220 in the slide-in direction (e.g., the -y-axis direction) and/or the slide-out direction (e.g., the y-axis direction) from the first housing 210. In some embodiments, in the electronic device 200, the first housing 210 may be slidably coupled to the second housing 220 depending on the disposition position of the driver (e.g., the drive motor 260 and the rack gear 262). In an embodiment, the first housing 210 may include a first side surface member 211 and a first rear surface cover 213 (e.g., a first rear bracket) coupled to at least a portion of the first side surface member 211. In an embodiment, the first space 2101 may be defined by the coupling of the first side surface member 211 and the first rear surface cover 213. In an embodiment, the electronic device 200 may include a side surface cover 2211a (e.g., a dielectric cover) disposed on the fourth side surface 2211 of the second side surface member 221.

According to various embodiments, the second housing 220 may include a second side surface member 221 and a second rear surface cover 223 (e.g., a second rear bracket or a window cover) coupled to at least a portion of the second side surface member 221. In an embodiment, the second space 2201 may be defined by the coupling of the second side surface member 221 and the second rear surface cover 223. In an embodiment, the second housing 220 may be coupled to the second side surface member 221 and may include a window cover 224 forming at least a portion of the rear surface of the second housing 220.

According to various embodiments, the driver (e.g., a drive module) may be disposed in the second space 2201 and may include a drive motor 260 including a pinion gear (e.g., the pinion gear 261 in FIG. 5A) and a rack gear 262 disposed to be gear-engaged with the pinion gear 261, fixed to a support bracket 225 disposed in the first space 2101, and extending from the first space 2101 to the second space 2201. In an embodiment, the electronic device 200 may further include a speed reduction module (e.g., a reduction gear assembly) structurally coupled to the drive motor so as to reduce the rotational speed and increase the driving force by being engaged with the drive motor 260. In an embodiment, the drive motor 260 may be disposed in the second space 2201 of the second housing 220 to be supported by at least a portion of the second side surface member 221 (e.g., the second extension member 222 in FIG. 5A). In an embodiment, the drive motor 260 may be disposed to be supported through a motor bracket (e.g., the motor bracket 260a in FIG. 5A) fixed to the second extension member 222. In some embodiments, the rack gear 262 may be guided in the sliding direction (e.g., the ±y-axis direction) through the motor bracket 260a. Accordingly, when the electronic device 200 is assembled, the pinion gear (e.g., the pinion gear 261 of FIG. 5A) may remain in a gear-engaged state with the rack gear 262, and as the pinion gear 261, which receives a driving force from the drive motor 260, moves along the rack gear 262, the second housing 220 may move in the slide-in direction (e.g., the -y-axis direction) or the slide-out direction (e.g., the y-axis direction) with respect to the first housing 210.

According to various embodiments, the electronic device 200 may include a support bracket 225 fixed in the first space 2101 of the first housing 210. In an embodiment, the electronic device 200 may include a pair of guide rails 226 (e.g., a linear motion (LM) guide) that are fixed to both sides of the support bracket 225 to guide both ends of the support member 240 in the sliding direction while simultaneously guiding the second housing 220 in the sliding direction. In an embodiment, the support bracket 225 and the pair of guide rails 226 may be fixed to the first housing 210 through fastening members such as screws. In an embodiment, the support bracket 225 may include a battery seating portion (e.g., the battery seating portion 2251 in FIG. 5A) configured to accommodate a battery B and a support portion (e.g., the support portion 2252 in FIG. 5A) provided at one end of the battery seating portion 2251 to support the rear surface of the support member 240 that bends during the sliding operation of the second housing 220. In an embodiment, the support portion 2252 may have a curved outer surface to smoothly guide the support member 240. In an embodiment, the support bracket 225 and the guide rails 226 may be fixed in the inner space 2101 of the first housing 210 through fastening members such as screws. In an embodiment, the electronic device 200 may further include a battery cover 2253 coupled to the support bracket 225 to cover the mounted battery B. In some embodiments, the battery cover 2253 may be omitted. In an embodiment, the rack gear 262 may be fixed through fastening members such as screws so as to extend from the outer surface of the support bracket 225 toward the second space 2201. In an embodiment, the rack gear 262 may be disposed at the center (e.g., a centrally symmetrical position) of the support bracket 225 so as to traverse the center of the electronic device 200 along the sliding direction of the second housing 220 (e.g., the ±y-axis direction). This central disposition may reduce power consumption by decreasing the increase in driving resistance caused by eccentricity during the sliding operation.

According to various embodiments, the electronic device 200 may include at least one electrical component (or electronic component) disposed in the second space 2201. In an embodiment, the at least one electrical component may include a first substrate 251 (e.g., a substrate assembly or a main substrate) (e.g., stacked substrates). In some embodiments, the at least one electrical component may be disposed in the first space 2101 of the first housing 210.

According to various embodiments, the electronic device 200 may include a second substrate 252 (e.g., a sub-substrate) and an antenna member 253, which are disposed between a first extension member (e.g., first extension member 212 in FIG. 5A) and the first rear surface cover 213 in the first housing 210. In an embodiment, the second substrate 252 and the antenna member 253 may be disposed on at least a portion of the first extension member 212. In an embodiment, the second substrate 252 and the antenna member 253 may be electrically connected to the first substrate 251 via at least one electrical connection member (e.g., a flexible printed circuit board (FPCB) or a flexible RF cable (FRC)). In an embodiment, the antenna member 253 may include a multi-function coil or multi-function core (MFC) antenna configured to execute a wireless charging function, a neat field communication (NFC) function, and/or an electronic payment function. In some embodiments, the second substrate 252 and/or the antenna member 253 may extend from the first space 2101 to the second space 2201 and may be electrically connected to the first substrate 251 through a flexibly deformable flexible substrate (a flexible printed circuit board (FPCB)).

According to various embodiments, the electronic device 200 may include a pair of guide blocks 227 fixed to the second housing 220 and slidably coupled to a pair of guide rails 226. In an embodiment, through the slidable coupling of the guide rails 226 and the guide blocks 227, the second housing 220 may be slid out from the first housing 210 by a specific distance (e.g., the first distance L1 of FIG. 3A).

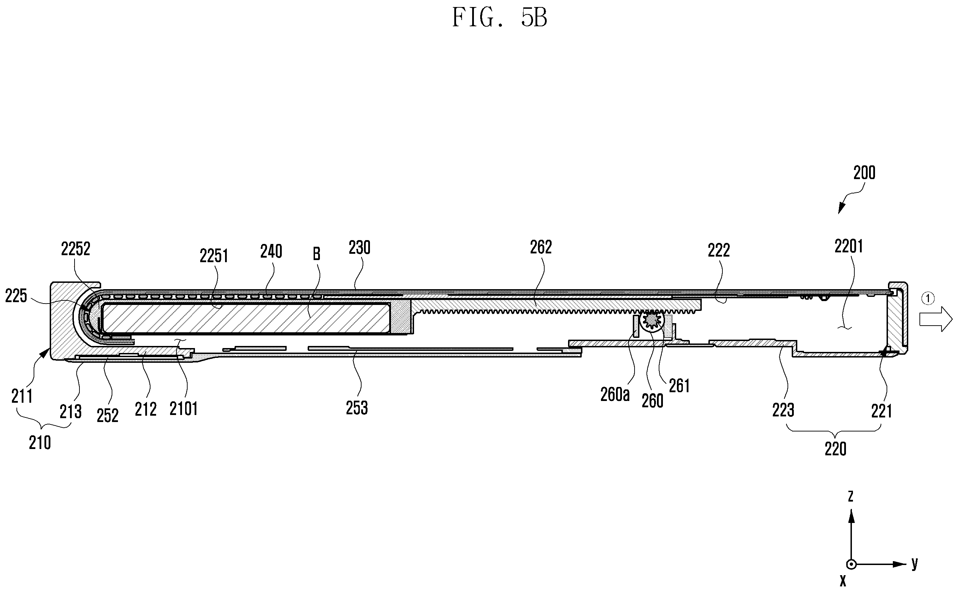

FIG. 5A is a cross-sectional view of the electronic device according to various embodiments of the disclosure taken along line 5a-5a in FIG. 2A. FIG. 5B is a cross-sectional view of the electronic device according to various embodiments of the disclosure taken along line 5b-5b in FIG. 3A.

In describing the electronic device 200 of FIGS. 5A and 5B, the same reference numerals are assigned to components that are substantially the same as those of the electronic device 200 of FIG. 4, and detailed descriptions thereof may be omitted.

Referring to FIGS. 5A and 5B, the electronic device 200 may include a first housing 210 having a first space 2101, a second housing 220 having a second space 2201, a support member 240 connected to the second housing 220 and at least partially accommodated in the first space 2101 in the slide-in state, a flexible display 230 disposed to be supported by at least a portion of the support member 240 and at least a portion of the second housing 220, a rack gear 262 fixed in the first space 2101 and extending into the second space 2201, and a drive motor 260 disposed in the second space 2201 and including a pinion gear 261 gear-engaged with the rack gear 262. In an embodiment, the drive motor 260 may automatically move the second housing 220 in the slide-out direction (direction ①) or the slide-in direction (direction ②) relative to the first housing 210 through the gear engagement between the pinion gear 261 and the rack gear 262. In some embodiments, by changing the disposition of the drive motor 260 and the rack gear 262, the first housing 210 may be automatically moved in the slide-out direction (direction ②) or the slide-in direction (direction ①) from the second housing 220. In an embodiment, the first housing 210 may include a first side surface member 211 and a first rear surface cover 213 coupled to a first extension member 212 extending from the first side surface member 211. In an embodiment, the second housing 220 may include a second side surface member 221 and a second rear surface cover 223 coupled to a second extension member 222 extending from the second side surface member 221.

According to various embodiments, a portion of the second housing 220 may be accommodated in the first space 2101 of the first housing 210 in the slide-in state of the electronic device 200 (the state of FIG. 5A). In an embodiment, at least a portion of the flexible display 230 may be accommodated in the first space 2101 in a bending manner together with the support member 240, thereby being disposed to be invisible from the outside. In this case, a first display area of the flexible display 230 (e.g., the display area corresponding to the first portion 230a in FIG. 3A) may be visually exposed to the outside.

According to various embodiments, at least a portion of the second housing 220 may transition to the slide-out state in which the second housing is at least partially moved to the outside from the first housing 210 along the first direction (direction ①) through the driving of the drive motor 260. In an embodiment, in the slide-out state of the electronic device 200 (the state of FIG. 5B), the flexible display 230 may be supported by the support bracket 225 and may move together with the support member 240, thereby exposing the portion accommodated in the first space 2101 to be at least partially visible from the outside. In this case, in the flexible display 230, a second display area (e.g., a display area including the first portion 230a and the second portion 230b in FIG. 3A), which is expanded beyond the first display area, may be visually exposed to the outside. In some embodiments, the rack gear 262 may be disposed in the second housing 220, and the drive motor 260 including the pinion gear 261 may be disposed in the first housing 210.

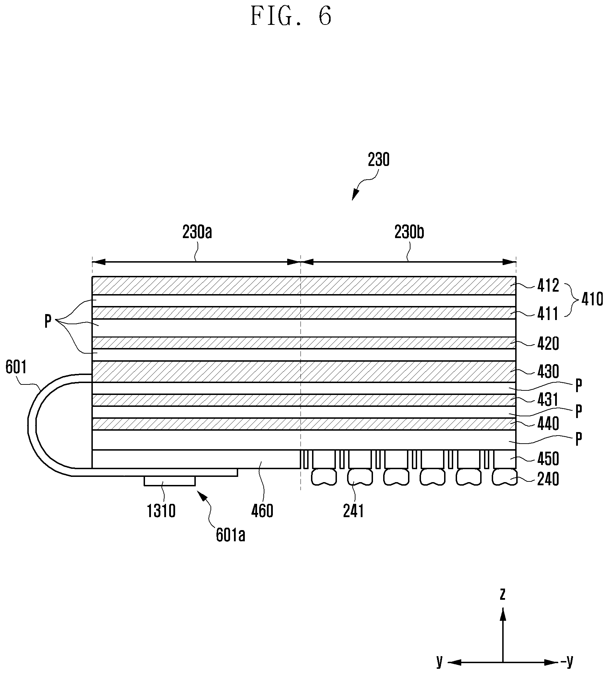

FIG. 6 is a schematic cross-sectional view of a flexible display according to an embodiment of the disclosure.

Referring to FIG. 6, according to various embodiments, the flexible display 230 may include a first portion 230a (e.g., a flat portion) that is always visible from the outside, and a second portion 230b (e.g., a bendable portion or a bending portion) that extends from the first portion 230a and is at least partially bent and accommodated into the first housing (e.g., the first housing 210 of FIGS. 2A to 5B) to be invisible from the outside in the slide-in state.

According to an embodiment, the flexible display 230 may include a window layer 410, a polarizer (POL) 420 (e.g., a polarizing film) sequentially disposed on the rear surface of the window layer 410, a display panel 430, a polymer layer 431, one or more functional layers 440, and a support plate 450. In an embodiment, regarding the flexible display 230, the support member 240 of the electronic device 200, configured to support at least a portion of the flexible display 230, may be disposed below the functional layer 440. In an embodiment, the support member 240 may include multiple support bars 241 (e.g., multiple bars) attached to the rear surface of the support plate 450 at a predetermined interval through bonding or welding. In an embodiment, the window layer 410, the polarizer 420, the display panel 430, the polymer layer 431, the one or more functional layers 440, the support plate 450, and the support member 240 may be attached to one another via adhesive layers P (e.g., an adhesive or bonding agent). For example, the adhesive layers P may include at least one of a pressure-sensitive adhesive (PSA), an optical clear adhesive (OCA), a heat-responsive adhesive, a general adhesive, or double-sided tape. In some embodiments, when the flexible display 230 is a POL-less display, the polarizing layer may be omitted, and a transparent reinforcement layer (e.g., a buffer layer) may be further disposed on that position. In some embodiment, the support plate 450 may be omitted.

According to various embodiments, the window layer 410 may include a glass layer. In an embodiment, the window layer 410 may include ultra-thin glass (UTG). In some embodiments, the window layer 410 may include polymer. In this case, the window layer 410 may include polyethylene terephthalate (PET) or polyimide (PI). In some embodiments, the window layer 410 may be arranged in multiple layers to include a first window layer 411 including a glass layer and a second window layer 412 including a polymer. In some embodiments, the flexible display 230 may further include a coating layer formed on at least a portion of the top surface, the rear surface, or the side surface of a glass layer formed as a part of the window layer 410 or a polymer (e.g., a protective film layer) disposed on the glass layer. For example, the coating layer may include a hard coating (HC) layer, an anti-reflection/low-reflection (AR/LR) coating layer, a shatter proof (SP) coating layer, or an anti-fingerprint (AF) coating layer. In some embodiments, the coating layer may be formed between the polymer and the glass layer, on the side surface of the polymer, or on at least one portion of the rear surface or the side surface of the glass layer.

According to various embodiments, a stacked structure of the display panel 430 may include: a flexible substrate (e.g., a polyimide substrate); a TFT layer including a plurality of TFTs disposed on the flexible substrate; a light-emitting element layer including light-emitting elements (e.g., organic light-emitting diodes (OLEDs)) that are disposed on the TFTs to form pixels; and a thin-film encapsulation layer TFE disposed on the light-emitting element layer to prevent oxygen and moisture from penetrating into the light-emitting elements. For example, the thin-film encapsulation layer may include an organic material. For example, the thin-film encapsulation layer may include a monomer. The TFT layer of the display panel 430 may include a plurality of TFTs configured to drive the light-emitting elements and a wiring structure (e.g., an electrode pattern). The light-emitting element layer may include an anode electrode (e.g., a first electrode) electrically connected to at least one TFT (e.g., a driving TFT) included in the TFT layer through a via, an organic light-emitting layer disposed on the anode electrode, and a cathode electrode (e.g., a second electrode) disposed on the organic light-emitting layer. The cathode electrode of the light-emitting element layer may be a common electrode stacked in common over a plurality of pixels.

In an embodiment, the polarizer 420 may selectively allow light, which is generated from a light source of the display panel 430 and vibrates in a predetermined direction, to pass therethrough. In an embodiment, the display panel 430 and the polarizer 420 may be integrally formed. In an embodiment, the flexible display 230 may include a touch panel (not illustrated).

According to an embodiment, the display panel 430 may be divided into a display area and a non-display area. According to an embodiment, the display area of the display panel 430 may have a plurality of pixels arranged therein and may display an image through the plurality of pixels. According to an embodiment, a wiring structure (e.g., an electrode pattern) may extend through the non-display area of the display panel 430 to be connected to the plurality of pixels. According to an embodiment, the non-display area of the display panel 430 may include a chip-on-panel (COP) area 601 in which a driver IC for driving the display panel 430 is mounted. For example, the COP area 601 may be connected to the first portion 230a (e.g., a flat portion) of the flexible display 230 that is visible from the outside in both the slid-in state and the slid-out state, and may be disposed in a bent state. According to an embodiment, a portion of the COP area 601 may include an IC area 601a on which a driver IC 1310 configured to drive the display panel 430 is mounted, and the IC area 601a, which is a portion of the COP area 601, may be attached below the one or more functional layer 440 with a spacer member 460 interposed therebetween. For example, the spacer member 460 may be disposed between the IC area 601a, which is a portion of the COP area 601, and the one or more functional layers 440.

According to an embodiment, on the side of the display panel 430 opposite to the COP area 601, a second portion 230b (e.g., a bendable portion or a bending portion) may be disposed to be at least partially bent and accommodated inside the first housing 210 in the slid-in state to be invisible from the outside.

According to various embodiments, the polymer layer 431 may serve as a protective film for protecting the display panel 430 by being disposed below the display panel 430. According to an embodiment, the polymer layer 431 may provide a dark background for ensuring visibility of the display panel 430 and may be formed of a buffer material to provide a buffering function. In some embodiments, in order to ensure waterproofing of the flexible display 230, the polymer layer 431 may be removed or disposed under the support plate 450.

According to various embodiments, the one or more functional layers 440 may include a protective layer (e.g., a thermoplastic polyurethane (TPU) layer or a polymer layer such as a polyethylene terephthalate (PET) layer) for reducing deformation caused by bending of the support member 240, a graphite sheet (or stainless steel (SUS), copper (Cu), or aluminum (Al)) for heat dissipation, a force touch FPCB, a fingerprint sensor FPCB, a communication antenna radiator, a conductive/non-conductive tape, or a digitizer. In an embodiment, the digitizer may include a plurality of conductive patterns (e.g., coil patterns) disposed on a dielectric substrate (e.g., a dielectric film or a dielectric sheet) to detect a resonant frequency induced by an electromagnetic induction method applied from an electronic pen.

According to various embodiments, the support plate 450 may provide rigidity and flexibility to the flexible display 230. For example, the support plate 450 may be made of a non-metallic sheet material, such as fiber-reinforced plastics (FRP) (e.g., carbon fiber-reinforced plastics (CFRP) or glass fiber-reinforced plastics (GFRP)), having a rigid property to support the display panel 430. In an embodiment, the support plate 450 may include a pattern (e.g., a lattice structure) that is disposed in an area corresponding to the support member 240 so as to help improve the flexibility of the flexible display 230. In an embodiment, the pattern may include a plurality of openings and/or recesses arranged at a predetermined interval. According to an embodiment, the support plate 450 may be formed of a non-metal thin plate material so as not to limit signal transmission of a digitizer configured to detect input from an external input device (e.g., an electronic pen). The bending characteristics of the support plate 450 may be determined by at least one of the size, shape, or arrangement density of at least some of the plurality of openings and/or recesses. In some embodiments, the support plate 450 may be made of a metal material such as SUS, Cu, Al, or a metal clad (e.g., a laminated member in which SUS and Al are alternately disposed). In an embodiment, the support plate 450 may help reinforce the rigidity of the electronic device 200, may shield ambient noise, and may be used as heat dissipation means to disperse heat emitted from surrounding heat-emitting components.

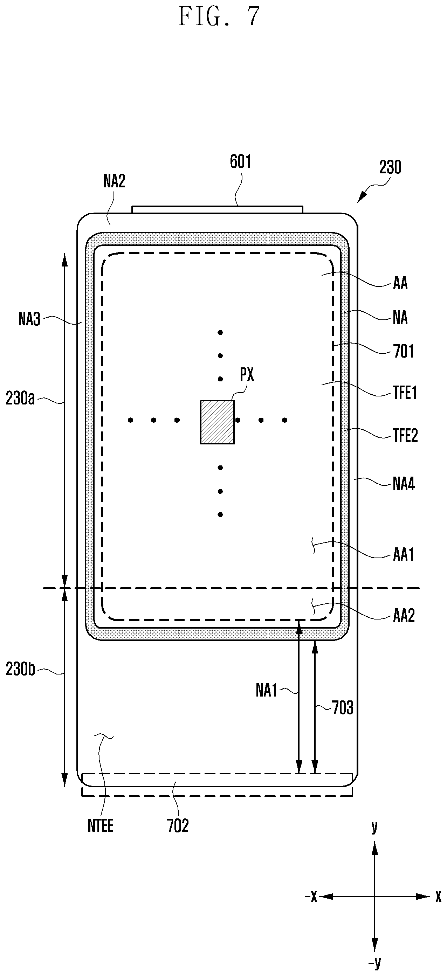

FIG. 7 is a plan view of a flexible display according to an embodiment of the disclosure.

Referring to FIG. 7, according to an embodiment, the flexible display 230 may include a first portion 230a (e.g., a flat portion or an upper end portion) that is visible from the outside in a first state (e.g., the slid-in state) and a second state (e.g., the slid-out state), and a second portion 230b (e.g., a bendable portion, a bending portion, or a lower end portion) that extends from the first portion 230a and is at least partially bent and accommodated inside the first housing 210 in the first state (e.g., the slide-in state) to be invisible from the outside.

According to an embodiment, the flexible display 230 may include a display area AA and a non-display area NA. In FIG. 7, the dotted area 701 may be a virtual area representing a boundary of the display area AA. According to an embodiment, an array of pixels PX may be disposed in the display area AA. According to an embodiment, the display area AA may include a first display area AA1 that is visually exposed from the outside in both a first state and a second state, and a second display area AA2 that is visually exposed from the outside in the second state. The second display area AA2 may be an area that is bent in response to movement of a housing (e.g., the first housing 210 or the second housing 220).

According to an embodiment, the non-display area NA may be an area disposed around the display area AA. For example, when the flexible display 230 is viewed from above, the non-display area NA may include an upper non-display area NA2 disposed in an upper direction (e.g., the y-axis direction) of the display area AA and including the COP area 601, a left non-display area NA3 disposed in a left direction (e.g., the -x-axis direction) of the display area AA, a right non-display area NA4 disposed in a right direction (e.g., the x-axis direction) of the display area AA, and a lower non-display area NA1 disposed in a lower direction (e.g., the -y-axis direction) of the display area AA. According to an embodiment, the lower non-display area NA1 may be a portion of the second portion 230b, which is at least partially bent and accommodated inside the first housing 210.

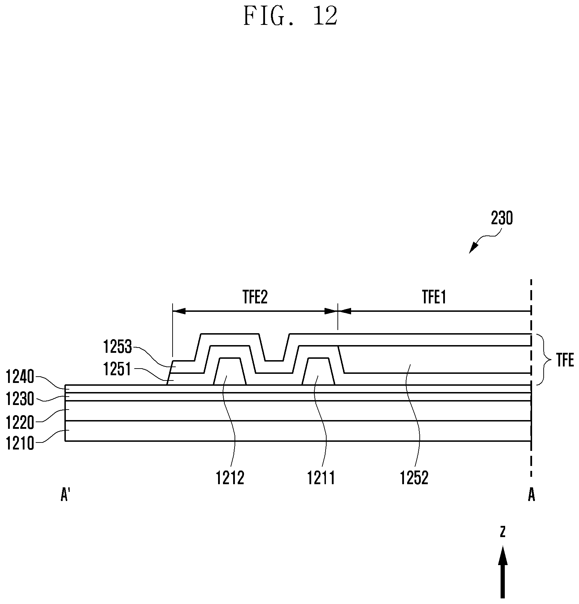

According to an embodiment, the flexible display 230 may include a thin-film encapsulation layer TFE that covers light-emitting elements (e.g., organic light-emitting diodes (OLEDs)) included in the pixels PX. According to an embodiment, the thin-film encapsulation layer TFE may serve to prevent moisture penetration and oxidation of the organic materials of the light-emitting elements. According to an embodiment, the thin-film encapsulation layer TFE may cover the light-emitting elements of the pixels PX in the display area AA and may extend into a portion of the non-display area NA. According to an embodiment, the thin-film encapsulation layer TFE may include a stacked structure of one or more organic layers (e.g., the organic layer 1252 of FIG. 12) and one or more inorganic layers (e.g., the inorganic layers 1251 and 1253). According to an embodiment, the thin-film encapsulation layer TFE may include a first inorganic layer 1251 (e.g., a first encapsulation layer), an organic layer 1252 (e.g., a second encapsulation layer) disposed on the first inorganic layer 1251, and a second inorganic layer 1253 (e.g., a third encapsulation layer) disposed on the organic layer 1252. According to an embodiment, the thin-film encapsulation layer TFE may include a first encapsulation area TFE1 in which the first inorganic layer 1251, the organic layer 1252, and the second inorganic layer 1253 are stacked, and a second encapsulation area TFE2 in which the first inorganic layer 1251 and the second inorganic layer 1253 are stacked without the organic layer 1252. According to an embodiment, the second encapsulation area TFE2 may be disposed to surround the first encapsulation area TFE1. For example, the second encapsulation area TFE2 may be an area disposed at an edge of the thin-film encapsulation layer TFE.

According to an embodiment of the disclosure, the term "inorganic layer" may be used interchangeably with the term "inorganic film."

According to an embodiment of the disclosure, the term "organic layer" may be used interchangeably with the term "organic film."

According to an embodiment, the flexible display 230 may include a non-encapsulation area NTFE disposed outside the thin-film encapsulation layer TFE. According to an embodiment, the non-encapsulation area NTFE may be an area disposed at the outermost edge of the flexible display 230 and may not be covered by the thin-film encapsulation layer TFE. For example, the non-encapsulation area NTFE may be an area adjacent to the end portion 702 of the flexible display 230. In FIG. 7, the arrow 703 may indicate the width of the non-encapsulation area NTFE in the lower non-display area NA1.

According to an embodiment, the area of the lower non-display area NA1 may be greater than each of the area of the upper non-display area NA2, the area of the left non-display area NA3, and the area of the right non-display area NA4. According to an embodiment, the thin-film encapsulation layer TFE may be disposed to extend into a portion of the lower non-display area NA1. According to an embodiment, the flexible display 230 may be configured such that the thin-film encapsulation layer TFE is disposed to extend into a portion of the lower non-display area NA1, so as to reduce interlayer peel-off in the second portion 230b that is bent in response to the movement of the housing.

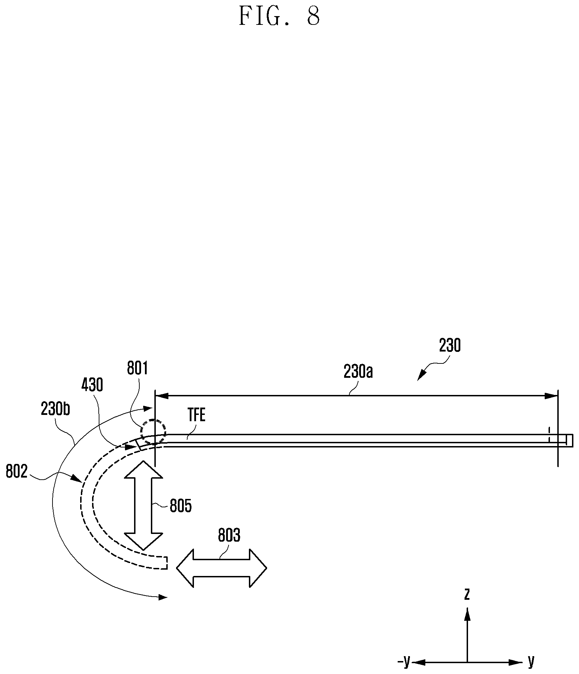

FIG. 8 is a cross-sectional view of a flexible display in a slide-out state, according to various embodiments of the disclosure.

The flexible display 230 illustrated in FIG. 8 may be at least partially similar to the flexible display 230 illustrated in FIG. 7.

Referring to FIG. 8, the thin-film encapsulation layer TFE of the display panel 430 may be disposed to cover the display area AA and may also be disposed to extend from the display area AA into the non-display area NA. For example, the thin-film encapsulation layer TFE may be disposed to extend into a portion of the lower non-display area NA1. According to an embodiment, the thin-film encapsulation layer TFE may extend to a boundary area 801 between the first portion 230a (e.g., a flat portion or an upper end portion) and the second portion 230b (e.g., a bendable portion, a bending portion, or a lower end portion) adjacent to the first portion 230a. According to an embodiment, by extending into a portion of the second portion 230b, the thin-film encapsulation layer TFE may reduce interlayer peel-off in the bending area 802 of the flexible display 230. The bending area 802 may be an area, the position of which changes depending on whether the electronic device 200 is in the slide-in state or the slide-out state. For example, the bending area 802 may be an area, the position of which changes depending on a change in the state of a housing (e.g., the first housing 210 or the second housing 220). For example, in the flexible display 230 according to an embodiment, interlayer peel-off may occur, in which at least some layers included in the flexible display 230 become separated due to a driving force 803 and/or a repulsive force 805 generated during sliding movement. According to an embodiment, the flexible display 230 may reduce interlayer peel-off by extending the thin-film encapsulation layer TFE to a boundary area 801 between a first portion 230a (e.g., a flat portion or an upper end portion) and a second portion 230b (e.g., a bendable portion, a bending portion, or a lower end portion) adjacent to the first portion 230a. For example, the thin-film encapsulation layer TFE may be disposed to extend into a portion of the lower non-display area NA1, so as to reduce interlayer peel-off in the second portion 230b that is bent in response to movement of the housing.

According to an embodiment of the disclosure, the term "bending area 802" may be used interchangeably with the term "bending portion."

According to an embodiment of the disclosure, the bending area (or bending portion) 802 may refer to a portion of the flexible display 230 that moves in response to movement of the second housing 220 and is bent with a predetermined radius of curvature.

According to an embodiment of the disclosure, the bending area (or bending portion) 802 may refer to a portion of the flexible display 230 that moves in response to movement of the first housing 210 and is bent with a predetermined radius of curvature.

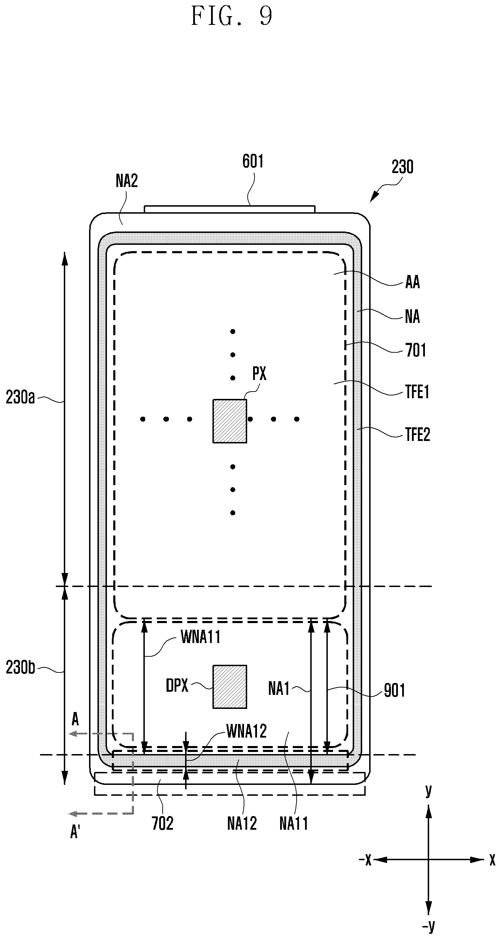

FIG. 9 is a plan view of a flexible display in which the arrangement of a thin-film encapsulation layer TFE is expanded, according to an embodiment.

The flexible display 230 illustrated in FIG. 9 may be at least partially similar to the flexible display 230 illustrated in FIG. 7 or may include various embodiments of the flexible display 230. Hereinafter, only the features of the flexible display 230 that differ in the embodiment of FIG. 9 will be described. Features not described with reference to FIG. 9 will be replaced by the description provided with reference to FIG. 7.

Unlike the embodiment of FIG. 7, the embodiment of FIG. 9 may be configured such that the thin-film encapsulation layer TFE extends into a portion of the lower non-display area NA1 adjacent to the end portion 702 of the flexible display 230.

Referring to FIG. 9, the flexible display 230 according to an embodiment may include a first portion 230a (e.g., a flat portion or an upper end portion) that is visible from the outside in both a first state (e.g., the slid-in state) and a second state (e.g., the slid-out state), and a second portion 230b (e.g., a bendable portion, a bending portion, or a lower end portion) that extends from the first portion 230a and is accommodated at least partially in a bent state inside the first housing 210 to be invisible from the outside in the first state (e.g., the slide-in state).

According to an embodiment, the flexible display 230 may include a display area AA and a non-display area NA. According to an embodiment, an array of pixels PX may be disposed in the display area AA. According to an embodiment, at least one dummy pixel DPX may be disposed in the non-display area NA, but is not limited thereto. For example, a dummy pixel DPX may be disposed in the lower non-display area NA1, but may be omitted.

According to an embodiment, the lower non-display area NA1 corresponding to the second portion 230b (e.g., a bendable portion, a bending portion, or a lower end portion) may include a first non-display area NA11 and a second non-display area NA12.

According to an embodiment, the first non-display area NA11 and the second non-display area NA12 may be areas extending in a direction in which the flexible display 230 moves from the display area AA when the electronic device 200 transitions from the slide-out state to the slide-in state, and may be areas not visually exposed from the outside.

According to an embodiment, the second non-display area NA12 may be an area extending in a direction in which the flexible display 230 moves from the first non-display area NA11 when the electronic device 200 transitions from the slide-out state to the slide-in state.

According to an embodiment, the first non-display area NA11 may be an area in which the thin-film encapsulation layer TFE has a stacked structure of one or more organic layers (e.g., the organic layer 1252 of FIG. 12) and one or more inorganic layers (e.g., the inorganic layers 1251 and 1253 of FIG. 12). According to an embodiment, the second non-display area NA12 may be an area in which the thin-film encapsulation layer TFE has a stacked structure of one or more inorganic layers 1251 and 1253. According to an embodiment, the second non-display area NA12 may be an area extending from the first non-display area NA11 in a first direction (e.g., the -y-axis direction) in which the end portion 702 of the flexible display 230 is positioned.

According to an embodiment, the area of the first non-display area NA11 may be greater than the area of the second non-display area NA12. For example, in FIG. 9, the arrow 901 may indicate the width of the first non-display area NA11. According to an embodiment, the width WNA11 of the first non-display area NA11 may be greater than the width WNA12 of the second non-display area NA12.

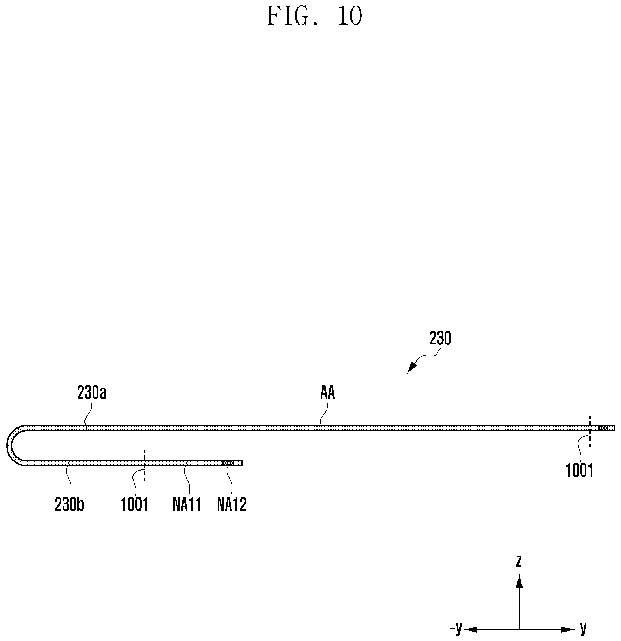

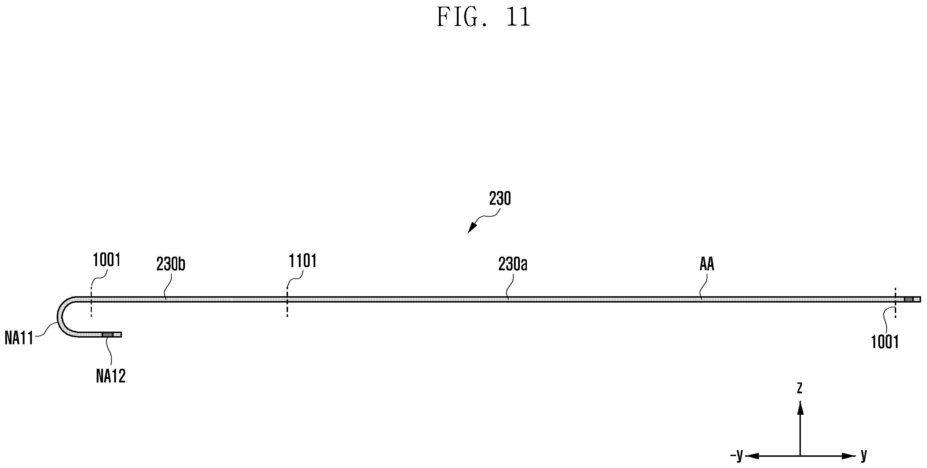

FIG. 10 is a cross-sectional view of a flexible display in a slide-in state, according to various embodiments of the disclosure. FIG. 11 is a cross-sectional view of a flexible display in a slide-out state, according to various embodiments of the disclosure.

The flexible display 230 illustrated in FIGS. 10 and 11 may be at least partially similar to the flexible display 230 illustrated in FIG. 9.

Referring to FIG. 10, in a first state (e.g., the slide-in state), the first portion 230a (e.g., a flat portion or an upper end portion) may be exposed to be visible from the outside, and the second portion 230b (e.g., a bendable portion, a bending portion, or a lower end portion) may be invisible from the outside. In FIG. 10, the dotted line 1001 may be an imaginary line indicating a boundary of the display area AA. According to an embodiment, the lower non-display area NA1 corresponding to the second portion 230b (e.g., a bendable portion, a bending portion, or a lower end portion) may include a first non-display area NA11 and a second non-display area NA12. According to an embodiment, the first non-display area NA11 may be an area in which the thin-film encapsulation layer TFE has a stacked structure of one or more organic layers (e.g., the organic layer 1252 of FIG. 12) and one or more inorganic layers (e.g., the inorganic layers 1251 and 1253 of FIG. 12). According to an embodiment, the second non-display area NA12 may be an area in which the thin-film encapsulation layer TFE has a stacked structure of one or more inorganic layers 1251 and 1253. According to an embodiment, the second non-display area NA12 may be an area extending from the first non-display area NA11 to the end portion of the flexible display 230 (e.g., the end portion 702 of FIG. 7). In the first state, the first non-display area NA11 and the second non-display area NA12 may be arranged in a non-bent state and in parallel with the display area AA.

Referring to FIG. 11, in the second state (e.g., the slide-out state), the first portion 230a (e.g., a flat portion or an upper end portion) and a portion of the second portion 230b (e.g., a bendable portion, a bending portion, or a lower end portion) may be exposed to be visible from the outside. In the second state, the first non-display area NA11 may be disposed in a bent state and may be invisible from the outside. In the second state, the second non-display area NA12 may be disposed in parallel with the display area AA and may be invisible from the outside. In FIG. 11, the dotted line 1101 may indicate a boundary of an additionally expanded display area in the second state (e.g., the slide-out state), for example, a boundary between the first portion 230a (e.g., a flat portion or an upper end portion) and the second portion 230b.

The flexible display 230 according to an embodiment illustrated in FIGS. 9 to 11 may reduce peel-off of the thin-film encapsulation layer TFE because the thin-film encapsulation layer TFE extends into a portion of the lower non-display area NA1 adjacent to the end portion 702 of the flexible display 230. For example, the flexible display 230 may reduce peel-off because the second non-display area NA12, in which the thin-film encapsulation layer TFE has a stacked structure of only one or more inorganic layers 1251 and 1253, is arranged in an area that is not bent in both the first and second states.

According to an embodiment, the second non-display area NA12 may be positioned so as not to be included in a bending portion (e.g., the bending area 802 of FIG. 8) of the flexible display 230, regardless of the state of the electronic device 200.

FIG. 12 is a cross-sectional view of the flexible display taken along line A-A' of FIG. 9, according to various embodiments of the disclosure. For example, FIG. 12 may be a cross-sectional view of a portion of the non-display area NA of the display panel 430.

Referring to FIG. 12, in the non-display area NA, the display panel 430 may have a substrate 1220 and a structure in which a substrate 1220, and a barrier layer 1230, a buffer layer 1240, and a thin-film encapsulation layer TFE are sequentially stacked on the substrate 1220. According to an embodiment, a protective film 1210 may be attached below the substrate 1220.

According to an embodiment, the substrate 1220 may be formed of a polymer such as polyimide, polyamide, polycarbonate, or polyethylene terephthalate, or a material such as glass, quartz, or ceramic.

According to an embodiment, the protective film 1210 may be formed of a plastic material such as polyethylene terephthalate, polyethylene naphthalate, polyimide, or polyethylene sulfide.

According to an embodiment, the barrier layer 1230 may serve as a moisture penetration prevention layer. For example, the barrier layer 1230 may be formed of silicon oxide (SiOₓ) or silicon nitride (SiNₓ).

According to an embodiment, the buffer layer 1240 may serve to block impurities that may diffuse into a semiconductor layer of the TFT layer disposed in the display area AA of the display panel 430, and to reduce stress applied to the substrate 1220.

According to an embodiment, the thin-film encapsulation layer TFE may serve as a layer that covers a light-emitting element (e.g., an OLED) disposed in the display area AA of the display panel 430 and prevents moisture or air from entering the light-emitting element. According to an embodiment, the thin-film encapsulation layer TFE may cover not only the display area AA but also a portion of the non-display area NA. According to an embodiment, the thin-film encapsulation layer TFE may include a stacked structure of one or more inorganic layers 1251 and 1253 and one or more organic layers 1252. According to an embodiment, the thin-film encapsulation layer TFE may include a first inorganic layer 1251 (e.g., a first encapsulation layer), an organic layer 1252 (e.g., a second encapsulation layer) disposed on the first inorganic layer 1251, and a second inorganic layer 1253 (e.g., a third encapsulation layer) disposed on the organic layer 1252. According to an embodiment, the thin-film encapsulation layer TFE may include a first encapsulation area TFE1 in which the first inorganic layer 1251, the organic layer 1252, and the second inorganic layer 1253 are stacked, and a second encapsulation area TFE2 in which the first inorganic layer 1251 and the second inorganic layer 1253 are stacked without the organic layer 1252. According to an embodiment, the second encapsulation area TFE2 may be disposed to surround the first encapsulation area TFE1. For example, the second encapsulation area TFE2 may be an area disposed at an edge of the thin-film encapsulation layer TFE.

According to an embodiment, the first inorganic layer 1251 and the second inorganic layer 1253 of the thin-film encapsulation layer TFE may be formed of a silicon oxide or a silicon nitride.

According to an embodiment, the organic layer 1252 of the thin-film encapsulation layer TFE may be formed of a material such as acrylic resin, methacrylic resin, polyisoprene, vinyl resin, epoxy resin, urethane resin, cellulose resin, or perylene resin.

According to an embodiment, the display panel 430 may include one or more dams 1211 and 1212 corresponding to a second encapsulation area TFE2 of the thin-film encapsulation layer TFE. According to an embodiment, the dams 1211 and 1212 may serve to prevent an organic material, such as a monomer, from overflowing when forming the organic layer of the thin-film encapsulation layer TFE. According to an embodiment, an edge of the organic layer 1252 of the thin-film encapsulation layer TFE may be positioned between the dams 1211 and 1212 and the display area AA, but is not limited thereto. According to an embodiment, the first inorganic layer 1251 and the second inorganic layer 1253 of the thin-film encapsulation layer TFE may be formed to cover the one or more dams 1211 and 1212 so as to increase a contact area.

According to an embodiment, the one or more dams 1211 and 1212 may include a first dam 1211 and a second dam 1212 disposed outside the first dam 1211, but is not limited thereto. For example, the display panel 430 may further include one or more dams outside the second dam 1212.

According to an embodiment, at least a portion of the thin-film encapsulation layer TFE may overlap a support member (e.g., the support member 240 of FIG. 6) configured to support at least a portion of the flexible display 230. For example, the support member 240 may include about 24 support bars (e.g., the support bars 241 of FIG. 6) (e.g., multiple bars). In this case, the first encapsulation area TFE1 of the thin-film encapsulation layer TFE may overlap about six to seven multiple bars, and the second encapsulation area TFE2 of the thin-film encapsulation layer TFE may overlap about seventeen to eighteen multiple bars, but is not limited thereto.

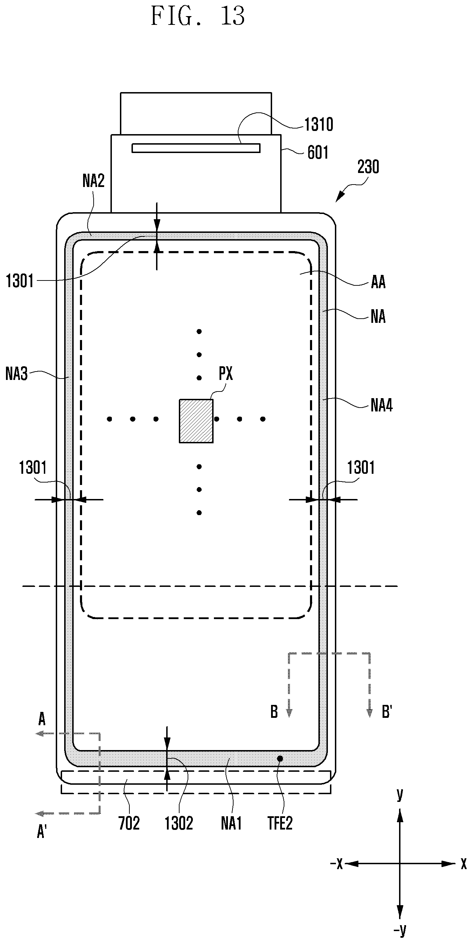

FIG. 13 is a plan view of a flexible display according to an embodiment of the disclosure.

The flexible display 230 illustrated in FIG. 13 may be at least partially similar to the flexible display 230 illustrated in FIGS. 7 and 9, or may include various embodiments of the flexible display 230. Hereinafter, only the features of the flexible display 230 that differ in the embodiment of FIG. 13 will be described. Features not described with reference to FIG. 13 will be replaced by the description provided with reference to FIGS. 7 and 9.

Unlike the embodiments of FIGS. 7 and 9, the embodiment of FIG. 13 may differ in that the width of the second encapsulation area TFE2 of the thin-film encapsulation layer TFE, which has a stacked structure of one or more inorganic layers 1251 and 1253, increases in the lower non-display area NA1.

Referring to FIG. 13, when the flexible display 230 is viewed from above, the non-display area NA may include an upper non-display area NA2 disposed above the display area AA and including a chip-on-panel (COP) area 601 where a driver IC 1310 configured to drive the display panel 430 is mounted, a left non-display area NA3 disposed to the left of the display area AA, a right non-display area NA4 disposed to the right of the display area AA, and a lower non-display area NA1 disposed below the display area AA. According to an embodiment, the lower non-display area NA1 may be a portion of the second portion 230b, which is at least partially bent and accommodated inside the first housing 210.

According to an embodiment, the thin-film encapsulation layer TFE extending from the display area AA may be disposed in each of the upper non-display area NA2, the left non-display area NA3, the right non-display area NA4, and the lower non-display area NA1, and may be divided into a first encapsulation area TFE1 and a second encapsulation area TFE2. According to an embodiment, the width of the second encapsulation area TFE2 may be differently designed in each of the upper non-display area NA2, the left non-display area NA3, the right non-display area NA4, and the lower non-display area NA1. For example, in the upper non-display area NA2, the left non-display area NA3, and the right non-display area NA4, the second encapsulation area TFE2 may have a first width 1301. For example, in the lower non-display area NA1, the second encapsulation area TFE2 may have a second width 1302 greater than the first width 1301. According to an embodiment, the flexible display 230 may reduce interlayer peel-off by increasing the width 1302 of the second encapsulation area TFE2 in the lower non-display area NA1.

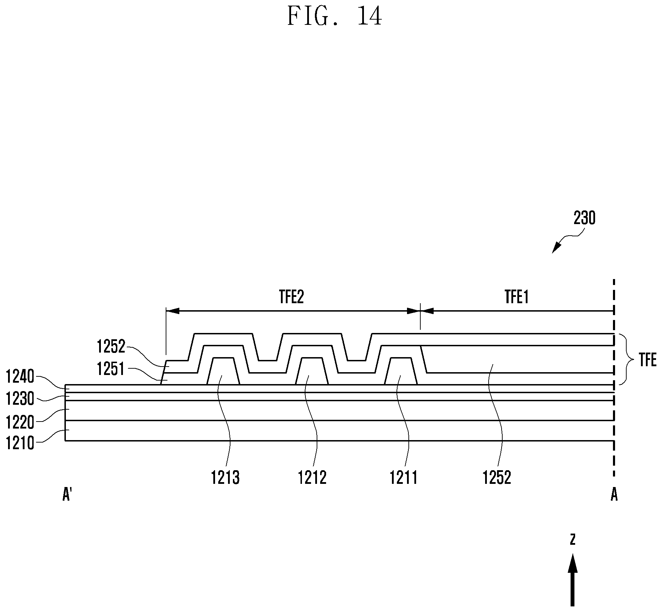

FIG. 14 is a cross-sectional view of the flexible display taken along line A-A' of FIG. 13, according to various embodiments of the disclosure.

The flexible display 230 illustrated in FIG. 14 may be at least partially similar to the flexible display 230 illustrated in FIG. 12 or may include various embodiments of the flexible display 230. Hereinafter, only the features of the flexible display 230 that differ in the embodiment of FIG. 14 will be described. Features not described with reference to FIG. 14 will be replaced by the description provided with reference to FIG. 12.

Referring to FIG. 14, in the lower non-display area NA1, the display panel 430 may include one or more dams corresponding to the second encapsulation area TFE2. According to an embodiment, the one or more dams may include a first dam 1211, a second dam 1212 disposed at a predetermined distance from the first dam 1211, and a third dam 1213 disposed at a predetermined distance from the second dam 1212.

According to an embodiment, the flexible display 230 may include a relatively large number of dams in the lower non-display area NA1. According to an embodiment, by including a relatively large number of dams in the lower non-display area NA1, peel-off of the thin-film encapsulation layer TFE may be reduced.

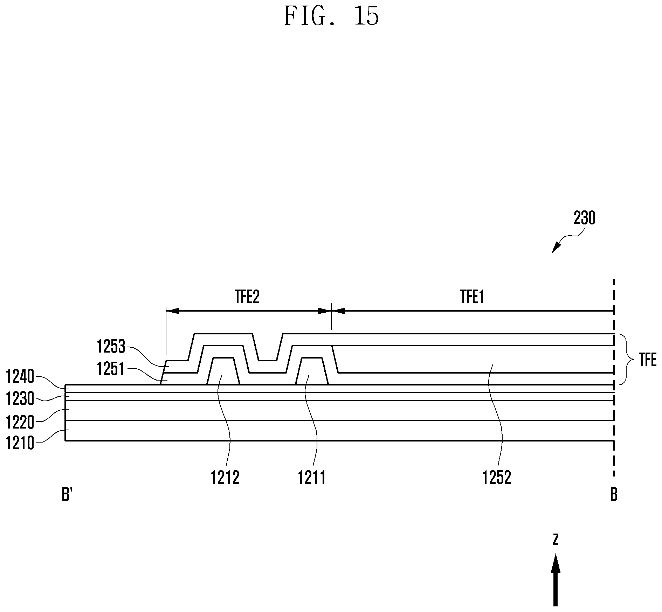

FIG. 15 is a cross-sectional view of the flexible display taken along line B-B' of FIG. 13, according to various embodiments of the disclosure. For example, FIG. 15 may be a cross-sectional view obtained by cutting a portion of the display panel 430 corresponding to the left non-display area NA3 or the right non-display area NA4.

The flexible display 230 illustrated in FIG. 15 may be at least partially similar to the flexible display 230 illustrated in FIG. 12 or may include various embodiments of the flexible display 230. Hereinafter, only the features of the flexible display 230 that differ in the embodiment of FIG. 15 will be described. Features not described with reference to FIG. 15 will be replaced by the description provided with reference to FIG. 12.

FIG. 15 may be a cross-sectional view illustrating a portion of a non-display area NA, such as a left non-display area (e.g., the left non-display area NA3 of FIG. 13) or a right non-display area (e.g., the right non-display area NA4 of FIG. 13), which is disposed on either side of a display area (e.g., the display area AA of FIG. 13). According to an embodiment, in the left non-display area NA3 or the right non-display area NA4, the display panel 430 may include one or more dams corresponding to the second encapsulation area TFE2. According to an embodiment, the one or more dams may include a first dam 1211 and a second dam 1212 disposed at a predetermined distance from the first dam 1211.

According to an embodiment, the flexible display 230 may include a relatively small number of dams in the left non-display area NA3 or the right non-display area NA4. For example, the flexible display 230 may include a predetermined number N of dams in the lower non-display area (e.g., the lower non-display area NA1 of FIG. 13), and may include a predetermined number M of dams less than N in the left non-display area NA3 or the right non-display area NA4.

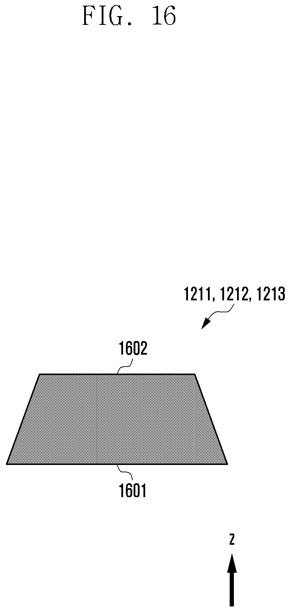

FIGS. 16 to 18 are cross-sectional views illustrating cross-sectional shapes of dams according to various embodiments. For example, FIGS. 16 to 18 may be cross-sectional views illustrating the cross-sectional shapes of the dams illustrated in FIG. 14.

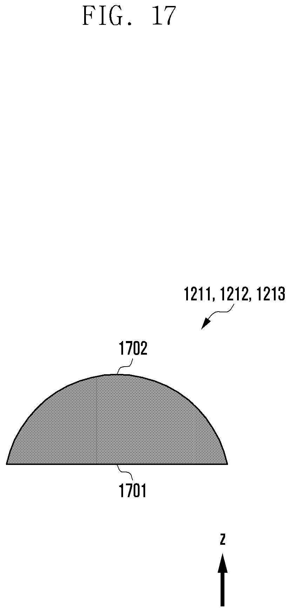

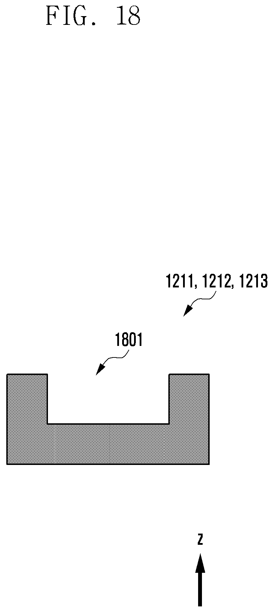

According to an embodiment, one or more dams disposed in the lower non-display area NA1, for example, the first dam 1211, the second dam 1212, or the third dam 1213, may have a substantially identical shape. For example, the first dam 1211, the second dam 1212, or the third dam 1213 may have the cross-sectional shape illustrated in FIG. 16. For example, the first dam 1211, the second dam 1212, or the third dam 1213 may have the cross-sectional shape illustrated in FIG. 17. For example, the first dam 1211, the second dam 1212, or the third dam 1213 may have the cross-sectional shape illustrated in FIG. 18. The cross-sectional size of the first dam 1211 may be equal to the cross-sectional size of the second dam 1212 or the third dam 1213.

According to an embodiment, one or more dams disposed in the lower non-display area NA1, for example, the first dam 1211, the second dam 1212, or the third dam 1213, may have different shapes from each other. For example, the first dam 1211, the second dam 1212, or the third dam 1213 may have one of the cross-sectional shapes illustrated in FIGS. 16, 17, and 18. The cross-sectional size of the first dam 1211 may be different from that of the second dam 1212 or the third dam 1213.

Referring to FIG. 16, the first dam 1211, the second dam 1212, or the third dam 1213 may have a positive taper shape, the width of which decreases from a lower portion 1601 to an upper portion 1602.

Referring to FIG. 17, the first dam 1211, the second dam 1212, or the third dam 1213 may have a shape that becomes convex from a lower portion 1701 to an upper portion 1702.

Referring to FIG. 18, the first dam 1211, the second dam 1212, or the third dam 1213 may have a shape including a concave groove 1801.

According to various embodiments, the distance between the first dam 1211 and the second dam 1212 may be greater than the width of the first dam 1211 corresponding to the lower portion (e.g., the lower portion 1601 in FIG. 16) of the cross-section of the first dam 1211.

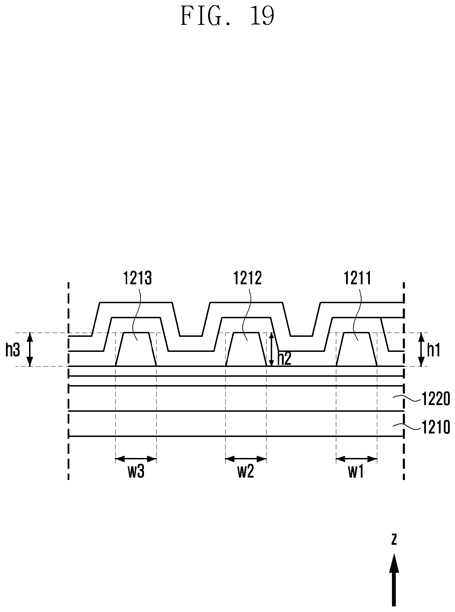

FIG. 19 is a cross-sectional view of the flexible display illustrating the dams of FIG. 13, according to various embodiments of the disclosure. For example, FIG. 19 may be a cross-sectional view illustrating the cross-sectional shapes of the dams illustrated in FIG. 14.

The flexible display 230 illustrated in FIG. 19 may be at least partially similar to the flexible display 230 illustrated in FIG. 14 or may include various embodiments of the flexible display 230. Hereinafter, only the features of the flexible display 230 that differ in the embodiment of FIG. 19 will be described. Features not described with reference to FIG. 19 will be replaced by the description provided with reference to FIG. 14.

Referring to FIG. 19, in the lower non-display area NA1, the display panel 430 may include one or more dams corresponding to the second encapsulation area TFE2. According to an embodiment, the one or more dams may include a first dam 1211, a second dam 1212 disposed at a predetermined distance from the first dam 1211, and a third dam 1213 disposed at a predetermined distance from the second dam 1212.

According to an embodiment, the first dam 1211 may have a first width w1 and a first height h1. For example, the cross-sectional shape of the first dam 1211 may have the first width w1 and the first height h1.

According to an embodiment, the second dam 1212 may have a second width w2 and a second height h2. For example, the cross-sectional shape of the second dam 1212 may have the second width w2 and the second height h2.

According to an embodiment, the third dam 1213 may have a third width w3 and a third height h3. For example, the cross-sectional shape of the third dam 1213 may have the third width w3 and the third height h3.

According to an embodiment, the first width w1, the second width w2, and the third width w3 may be equal to each other, and the first height h1, the second height h2, and the third height h3 may be equal to each other.

According to an embodiment, the first width w1, the second width w2, and the third width w3 may be different from each other, and the first height h1, the second height h2, and the third height h3 may be different from each other.

As illustrated in FIG. 19, according to an embodiment, the first dam 1211, the second dam 1212, and the third dam 1213 may all be formed to have the equal size. According to an embodiment, the first dam 1211, the second dam 1212, and the third dam 1213 may be made of the same component (e.g., laminated structure), in which case the ease of production may be improved. According to an embodiment, the structure of each of the first dam 1211, the second dam 1212, and the third dam 1213 may have a cross-sectional structure in the form of a positive taper.

According to an embodiment, the first dam 1211, the second dam 1212, and the third dam 1213 may have different sizes, respectively. For example, the first dam 1211, which is positioned closest to the organic film 1252, may have a greater height than the second dam 1212 and the third dam 1213 in order to prevent the overflow of the organic film 1252. According to an embodiment, the third dam 1213 may serve to prevent lifting of a film and may include a structure configured to increase adhesion to the lower layer (e.g., the buffer layer 1240 of FIG. 14). For example, the third dam 1213 may be designed to have a relatively larger contact area with the lower layer compared to the first dam 1211 and the second dam 1212 to increase adhesion.

According to an embodiment, the first dam 1211, the second dam 1212, and the third dam 1213 may have the same or different components (e.g., stacked structures). For example, the third dam 1213 may include an adhesive material with high adhesion in order to increase adhesion.

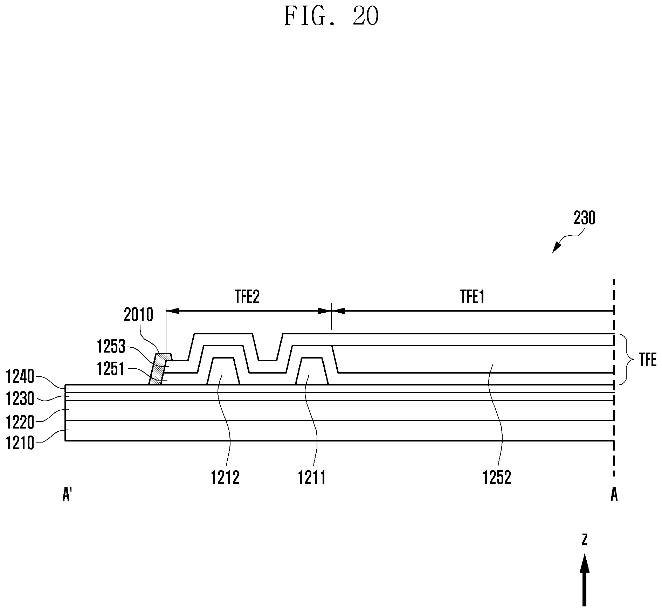

FIG. 20 is a cross-sectional view of a flexible display including a peel-off prevention dam 2010 according to an embodiment.

The flexible display 230 illustrated in FIG. 20 may be at least partially similar to the flexible display 230 illustrated in FIG. 12 or may include various embodiments of the flexible display 230. Hereinafter, only the features of the flexible display 230 that differ in the embodiment of FIG. 20 will be described. The features not described with reference to FIG. 20 will be replaced by the description provided with reference to FIG. 12.

Referring to FIG. 20, a flexible display 230 according to an embodiment may further include a peel-off prevention dam 2010. According to an embodiment, in the second non-display area NA12, the peel-off prevention dam 2010 may be disposed outside the one or more dams. According to an embodiment, the peel-off prevention dam 2010 may cover an end portion of the thin film encapsulation layer TFE. According to an embodiment, the height of the peel-off prevention dam 2010 may be greater than the heights of the first dam 1211 and the second dam 1212. According to an embodiment, the width of the peel-off prevention dam 2010 may be smaller than the width of the first dam 1211 or the second dam 1212. According to an embodiment, the components (e.g., a stacked structure) of the peel-off prevention dam 2010 may be different from those (e.g., a stacked structure) of each of the first dam 1211 and the second dam 1212. According to an embodiment, unlike the first dam 1211 and the second dam 1212, the peel-off prevention dam 2010 may include a material having high adhesive strength and rigidity.

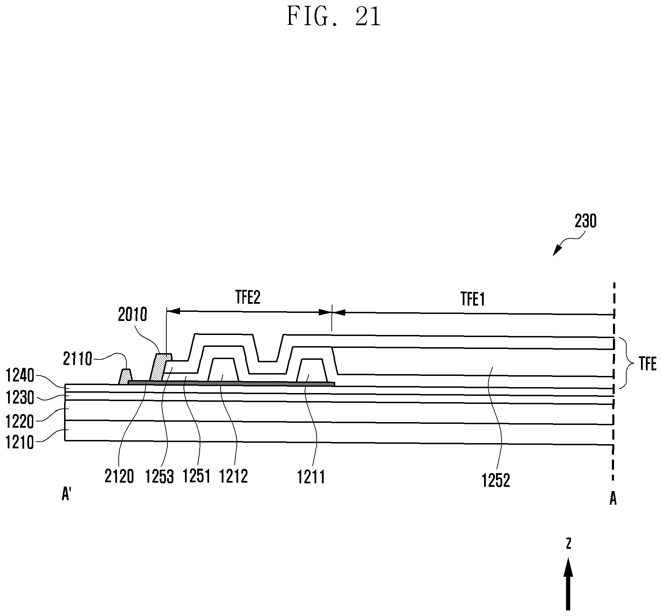

FIG. 21 is a cross-sectional view of a flexible display including a crack prevention dam 2110 according to an embodiment.

The flexible display 230 illustrated in FIG. 21 may be at least partially similar to the flexible display 230 illustrated in FIGS. 12 and 20, or may include various embodiments of the flexible display 230. Hereinafter, only the features of the flexible display 230 that differ in the embodiment of FIG. 21 will be described. The features not described with reference to FIG. 21 will be replaced by the description provided with reference to FIGS. 12 and 20.

Referring to FIG. 21, a flexible display 230 according to an embodiment may further include a crack prevention dam 2110. According to an embodiment, in the second non-display area NA12, the crack prevention dam 2110 may be disposed outside the peel-off prevention dam 2010. According to an embodiment, the size (e.g., height or width) of the crack prevention dam 2110 may be smaller than the size (e.g., height or width) of the peel-off prevention dam 2010, or the size (e.g., height or width) of each of the first dam 1211 and the second dam 1212.

According to an embodiment, the components (e.g., a stacked structure) of the crack prevention dam 2110 may be substantially identical to the components (e.g., a stacked structure) of the peel-off prevention dam 2010.

According to an embodiment, the components (e.g., a stacked structure) of the crack prevention dam 2110 may be different from the components (e.g., a stacked structure) of the peel-off prevention dam 2010. For example, the adhesive strength of a material included in the crack prevention dam 2110 may be greater than the adhesive strength of a material included in the peel-off prevention dam 2010. For example, the adhesive strength of a material included in the crack prevention dam 2110 may be lower than the adhesive strength of a material included in the peel-off prevention dam 2010.

According to an embodiment, the crack prevention dam 2110 may be disposed at an edge of the substrate 1220 and may serve to cover an end portion of a power wire. According to an embodiment, the crack prevention dam 2110 may serve to reduce damage (e.g., cracks) to an inorganic insulating layer such as the barrier layer 1230 or the buffer layer 1240 in a cutting press of the display panel 430.

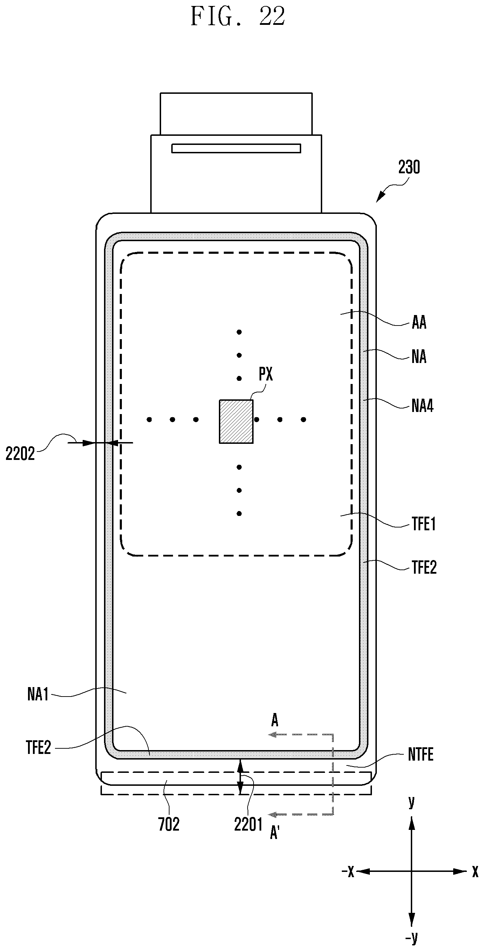

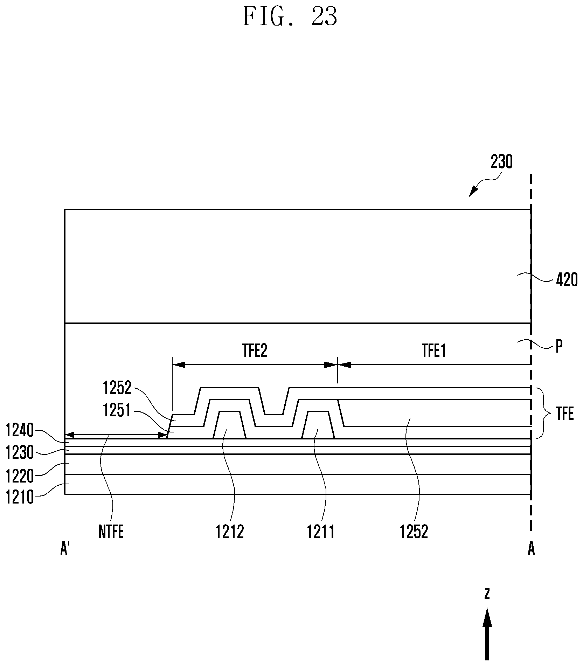

FIG. 22 is a plan view of a flexible display according to an embodiment of the disclosure. FIG. 23 is a cross-sectional view of the flexible display taken along line A-A' of FIG. 22, according to various embodiments of the disclosure.

The flexible display 230 illustrated in FIG. 22 may be at least partially similar to the flexible display 230 illustrated in FIGS. 7 and 9, or may include various embodiments of the flexible display 230. Hereinafter, only the features of the flexible display 230 that differ in the embodiment of FIG. 22 will be described. The features not described with reference to FIG. 22 will be replaced by the description provided with reference to FIGS. 7 and 9.

The flexible display 230 illustrated in FIG. 23 may be at least partially similar to the flexible display 230 illustrated in FIG. 12 or may include various embodiments of the flexible display 230. Hereinafter, only the features of the flexible display 230 that differ in the embodiment of FIG. 23 will be described. The features not described with reference to FIG. 23 will be replaced by the description provided with reference to FIG. 12.

Referring to FIG. 22, the width of the unencapsulated area NTFE, which is not covered by the thin film encapsulation layer TFE, may increase in the lower non-display area NA1. For example, the unencapsulated area NTFE may have the greatest width in the lower non-display area NA1. For example, in each of the upper non-display area NA2, the left non-display area NA3, the right non-display area NA4, and the lower non-display area NA1, the thin film encapsulation layer TFE extending from the display area AA may be disposed, and the unencapsulated area NTFE may be disposed outside the thin film encapsulation layer TFE. According to an embodiment, the width of the unencapsulated area NTFE may be differently designed in each of the upper non-display area NA2, the left non-display area NA3, the right non-display area NA4, and the lower non-display area NA1. For example, in the upper non-display area NA2, the left non-display area NA3, and the right non-display area NA4, the unencapsulated area NTFE may have a first width 2202. For example, in the lower non-display area NA1, the unencapsulated area NTFE may have a second width 2201 greater than the first width 2202. According to an embodiment, the flexible display 230 may reduce interlayer peel-off by increasing the width of the unencapsulated area NTFE in the lower non-display area NA1.

Referring to FIG. 23, an adhesive layer (e.g., the adhesive layer P of FIG. 6) (e.g., a pressure-sensitive adhesive or an adhesive) for attaching to a structure (e.g., the polarizer 420) positioned above the unencapsulated area NTFE may be attached to the unencapsulated area NTFE in the lower non-display area NA1. For example, the adhesive layer P may extend from the unencapsulated area NTFE to the second encapsulation area TFE2 and the first encapsulation area TFE1.

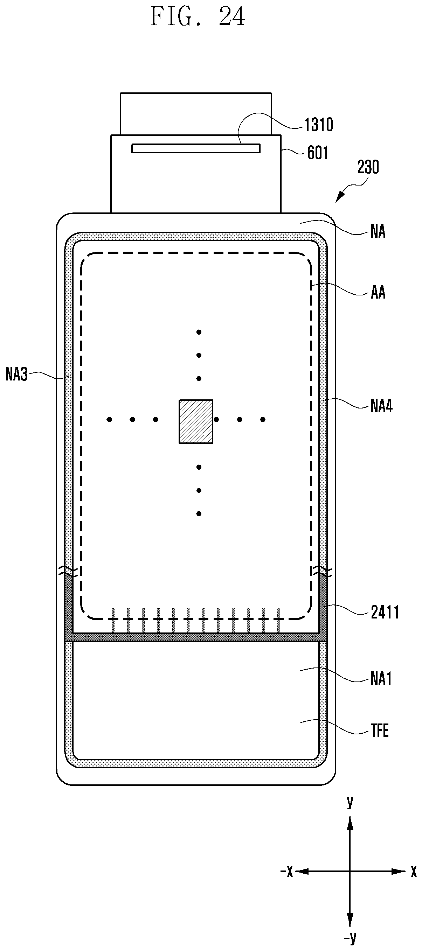

FIG. 24 is a plan view illustrating a wiring structure of a flexible display according to an embodiment of the disclosure.

The flexible display 230 illustrated in FIG. 24 may be at least partially similar to the flexible display 230 illustrated in FIGS. 7 and 9, or may include various embodiments of the flexible display 230. Hereinafter, only the features of the flexible display 230 that differ in the embodiment of FIG. 24 will be described. The features not described with reference to FIG. 24 will be replaced by the description provided with reference to FIGS. 7 and 9.

Referring to FIG. 24, a flexible display 230 according to an embodiment may include a power wire 2411 configured to drive pixels PX disposed in a display area AA. According to an embodiment, the power wire 2411 may be disposed to extend from the display area AA to the lower non-display area NA1, and may be connected to the driver IC 1310 of a chip-on-panel (COP) area 601 via the left non-display area NA3 and the right non-display area NA4 in a portion of the lower non-display area NA1. According to an embodiment, the power wire 2411 may include, for example, a high-potential voltage wire (e.g., ELVDD) or a low-potential voltage wire (e.g., ELVSS) configured to drive an array of pixels PX.

According to an embodiment, the power wire 2411 may extend to the lower non-display area NA1 but may be arranged so as not to overlap the second encapsulation area TFE2 of the thin film encapsulation layer TFE. For example, the arrangement of the power wire 2411 may be designed such that the wire extends to the lower non-display area NA1 but does not overlap the second encapsulation area TFE2, which includes only an inorganic film. The power wire 2411 may extend from the lower non-display area NA1 to the first encapsulation area TFE1, and may be bent in the first encapsulation area TFE1 to extend to the left non-display area NA3 and the right non-display area NA4.

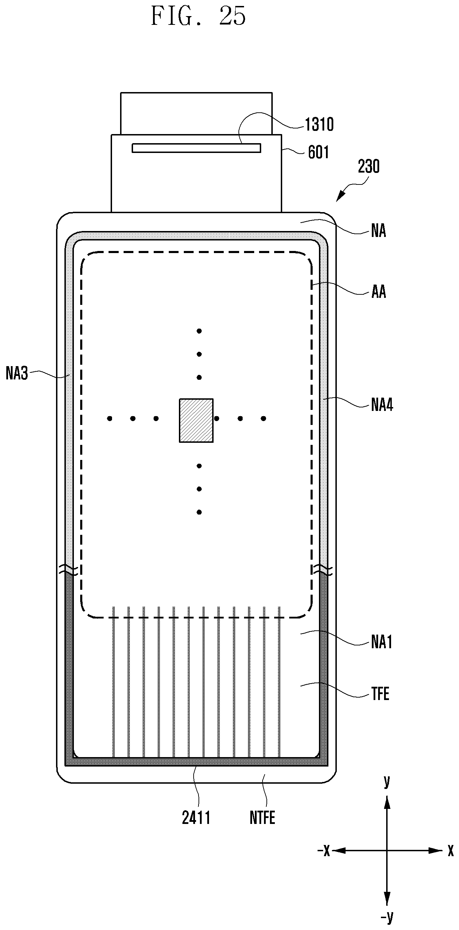

FIG. 25 is a plan view illustrating an example in which the wiring structure of a flexible display is modified according to an embodiment.

The flexible display 230 illustrated in FIG. 25 may be at least partially similar to the flexible display 230 illustrated in FIG. 24 or may include various embodiments of the flexible display 230. Hereinafter, only the features of the flexible display 230 that differ in the embodiment of FIG. 25 will be described. The features not described with reference to FIG. 25 will be replaced by the description provided with reference to FIG. 24.

In the embodiment of FIG. 25, unlike the embodiment of FIG. 24, the power wire 2411 may extend to the lower non-display area NA1 and further to the second encapsulation area TFE2 of the thin film encapsulation layer TFE. According to an embodiment, the power wire 2411 may extend from the lower non-display area NA1 to the second encapsulation area TFE2 and may be bent in the second encapsulation area TFE2 to extend to the left non-display area NA3 and the right non-display area NA4. According to an embodiment, by allowing the power wire 2411 to extend to the second encapsulation area TFE2, damage (e.g., cracks) to the wire may be reduced.

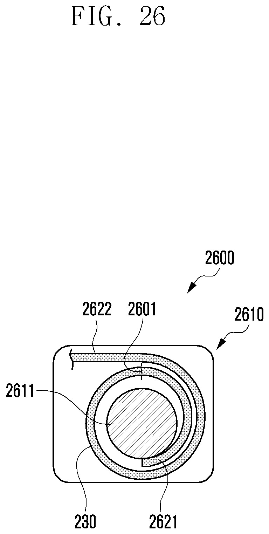

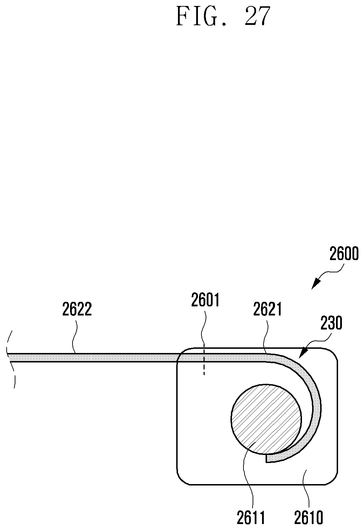

FIG. 26 is a schematic view of an electronic device in a slide-in state according to an embodiment. FIG. 27 is a schematic view of the electronic device in a slide-out state according to an embodiment.

Referring to FIGS. 26 and 27, an electronic device 2600 according to an embodiment may have a rollable form factor in which a flexible display 230 moves to wrap around or unroll from the outer surface of a roller disposed inside a housing 2610, unlike the electronic device 200 described with reference to FIGS. 2A to 5B. For example, in the slide-in state, the flexible display 230 may be disposed inside the housing 2610 and may be arranged to wrap around the outer surface of the roller 2611 inside the housing 2610. For example, in the slide-out state, a portion of the flexible display 230 may be slid out of the housing 2610, while another portion of the flexible display 230 may remain disposed inside the housing 2610 so as to be maintained in a state invisible from the outside. As illustrated in FIGS. 26 and 27, in the slide-out state, the flexible display 230 may include a first portion 2622 that is exposed to be visible from the outside, and a second portion 2621 that is not exposed and thus invisible from the outside in both the slide-out state and the slide-in state. In FIGS. 26 and 27, the dotted line 2601 may represent an imaginary boundary line 2601 that separates the first portion 2622 and the second portion 2621 of the flexible display 230.

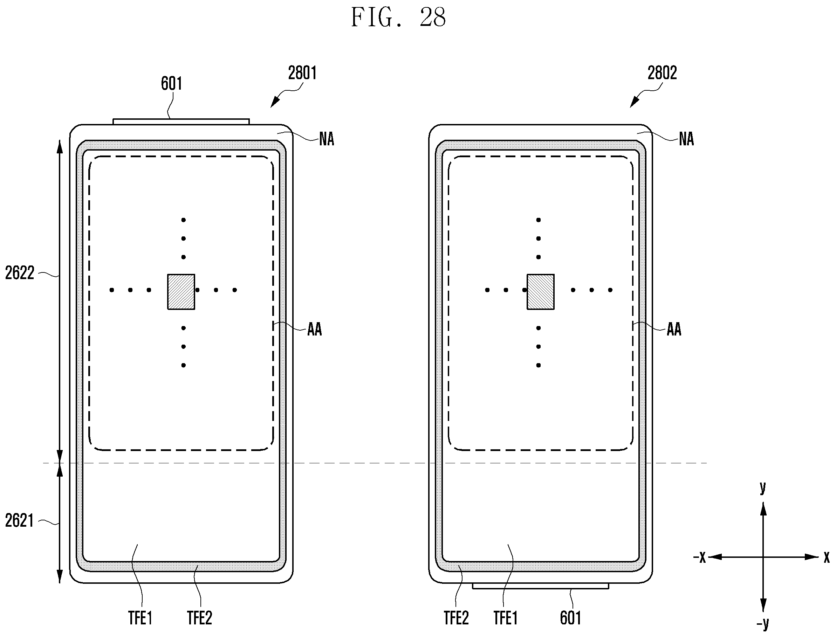

FIG. 28 is a plan view of the flexible display illustrated in FIG. 26 and/or FIG. 27.

The flexible displays 2801 and 2802 illustrated in FIG. 28 may be at least partially similar to the flexible display 230 illustrated in FIGS. 9, 26, and 27, or may include various embodiments of the flexible display. In the following description, only the features of the flexible displays 2801 and 2802 that differ in the embodiment of FIG. 28 will be described. The features not described with reference to FIG. 28 will be replaced by the descriptions provided with reference to FIGS. 9, 26, and 27.

Referring to FIG. 28, the flexible displays 2801 and 2802 (e.g., the flexible display 230 of FIG. 9) may include a first portion 2622 that is exposed to be visible from the outside in a slide-out state (e.g., a first state), and a second portion 2621 that is disposed inside the housing 2610 and thus invisible from the outside in both the slide-out state and a slide-in state (e.g., a second state). According to an embodiment, the first portion 2622 may include a display area AA, and an outer area of the display area AA may be defined as a non-display area NA.

According to an embodiment, at least a portion of the second portion 2621 may be covered by a thin film encapsulation layer TFE. According to an embodiment, in the second portion 2621, the thin film encapsulation layer TFE may include a first encapsulation area TFE1 having a stacked structure of one or more inorganic films (e.g., inorganic films 1251 and 1253 of FIG. 12) and one or more organic films (e.g., the organic film 1252 of FIG. 12), and a second encapsulation area TFE2 disposed outside the first encapsulation area TFE1 and having a stacked structure of one or more inorganic films 1251 and 1253.

According to an embodiment, the non-display area NA of the flexible displays 2801 and 2802 may include a chip-on-panel (COP) area 601 on which a driver IC (e.g., the driver IC 1310 of FIG. 25) is mounted. According to an embodiment, as in the flexible display 2801 of FIG. 28, the COP area 601 may be a partial area of the non-display area NA corresponding to the first portion 2622. For example, the COP area 601 may extend from the non-display area NA corresponding to the first portion 2622. According to an embodiment, as in the flexible display 2802 of FIG. 28, the COP area 601 may be a partial area of the non-display area NA corresponding to the second portion 2621. For example, the COP area 601 may extend from the non-display area NA corresponding to the second portion 2621. According to embodiments of the disclosure, the reliability of an electronic device may be improved by providing a flexible display that is resistant to stress during bending and reduces interlayer peel-off.

In addition, various effects that are directly or indirectly understood from this document may also be provided.

The effects that are capable of being obtained by the disclosure are not limited to those described above, and other effects not described above may be clearly understood by a person ordinarily skilled in the art to which the disclosure belongs.

According to an embodiment of the disclosure, an electronic device (e.g., the electronic device 200 of FIG. 2A) may include a first housing 210, a second housing 220 movably coupled to the first housing 210 so as to allow the electronic device 200 to transition between a slide-in state and a slide-out state, and a flexible display (e.g., the flexible display 230 of FIG. 2A) disposed in the first housing 210 and the second housing 220 and including a bending portion configured to move in response to movement of the second housing 220 and to be bent with a predetermined curvature radius. The flexible display 230 may include a display area (e.g., the display area AA of FIG. 9) in which a plurality of pixels are activated, a first non-display area (e.g., the first non-display area NA11 of FIG. 9) extending in a first direction from the display area AA, the first direction being a direction in which the flexible display 230 moves when the electronic device transitions from the slide-out state to the slide-in state, and a second non-display area NA12 extending from the first non-display area in the first direction. The first non-display area NA1 may be an area in which a thin-film encapsulation layer having a structure in which an organic layer is disposed between two inorganic layers is formed, and the second non-display area NA12 may be an area in which a thin-film encapsulation layer having a structure in which the two inorganic layers are laminated is formed. A position of the bending portion on the flexible display 230 may change in response to the state transition of the electronic device 200, and the second non-display area NA12 may be positioned so as not to be included in the bending portion in any state of the electronic device 200.

The thin-film encapsulation layer TFE may include a first encapsulation area TFE1 including a first encapsulation layer including an inorganic layer, a second encapsulation layer disposed on the first encapsulation layer and including an organic layer, and a third encapsulation layer disposed on the second encapsulation layer and including an inorganic layer, and a second encapsulation area TFE2 disposed around the first encapsulation area TFE1 and including the first encapsulation layer and the third encapsulation layer. The first encapsulation area TFE1 may be disposed to correspond to the display area AA and the first non-display area NA11, and the second encapsulation area TFE2 may be disposed to correspond to the second non-display area NA12.

The electronic device may further include one or more dams 1211, 1212, and 1213 disposed in the second non-display area NA12, and the thin-film encapsulation layer TFE may cover the one or more dams 1211, 1212, and 1213.

The one or more dams 1211, 1212, and 1213 disposed in the second non-display area NA12 may include a first dam 1211 having a first width and a first height, a second dam 1212 having a second width and a second height and disposed at a predetermined distance from the first dam 1211, and a third dam 1213 having a third width and a third height and disposed at a predetermined distance from the second dam 1212.

The first width, the second width, and the third width may be equal to each other, and the first height, the second height, and the third height may be equal to each other.

The first width, the second width, and the third width may be different from each other, and the first height, the second height, and the third height may be different from each other.

The first dam 1211, the second dam 1212, and the third dam 1213 may have identical cross-sectional shapes.

The first dam 1211, the second dam 1212, and the third dam 1213 may have different cross-sectional shapes.

The non-display area may further include a third non-display area extending in a second direction perpendicular to the first direction from the first display area AA or the second display area AA, and the number of the one or more dams 1211, 1212, and 1213 disposed in the third non-display area may be less than the number of dams 1211, 1212, and 1213 disposed in the second non-display area NA12.

In the second non-display area NA12, the electronic device may further include a peel-off prevention dam 2010 disposed outside the one or more dams 1211, 1212, and 1213 and covering an end of the thin-film encapsulation layer TFE.

In the second non-display area NA12, the electronic device may further include a crack prevention dam 2110 disposed outside the peel-off prevention dam 2010 and having a size smaller than that of the peel-off prevention dam 2010.

An electronic device 200 according to an embodiment of the disclosure may include a first housing 210, a second housing 220 movably coupled to the first housing 210 so as to allow the electronic device 200 to transition between a slide-in state and a slide-out state, and a flexible display 230 including an upper end portion fixed to at least a portion of the first housing 210, and a lower end portion configured to move inside the second housing 220 in response to movement of the second housing 220. The lower end portion of the flexible display 230 may include a first area including a pixel array, a second area including a first inorganic layer, a second inorganic layer, and an organic layer positioned between the first inorganic layer and the second inorganic layer, and a third area including the first inorganic layer, the second inorganic layer, and a dam positioned below the first inorganic layer and the second inorganic layer. In the slide-in state, at least a portion of the first area may be disposed in a bent state, and in the slide-out state, at least a portion of the second area may be disposed in a bent state.

In the slide-out state, the third area may be disposed in a non-bent state and parallel to the upper end portion.

The electronic device may further include a battery disposed in the second housing 220, and the third area may be disposed, in the slide-out state, between the battery and a rear surface of the second housing 220.

The second area may be disposed, in the slide-in state, between the battery and the rear surface of the second housing 220.

The second area may have an area larger than that of the third area.

A cross-sectional shape of the dam may be a regular taper shape in which a width decreases from bottom to top.

The dam may include a first dam 1211 and a second dam 1212, and the distance between the first dam 1211 and the second dam 1212 may be greater than the width of the first dam 1211 at the bottom of the cross-section thereof.

The first dam 1211 may have a cross-sectional size different from that of the second dam 1212.

The dam may further include a third dam 1213, and the third dam 1213 may have a cross-sectional size different from that of the first dam 1211.

## Claims

1. An electronic device (200) comprising:
a first housing (210);
a second housing (220) movably coupled to the first housing (210) so as to allow the electronic device (200) to transition between a slide-in state and a slide-out state; and
a flexible display (230) disposed in the first housing (210) and the second housing (220) and comprising a bending portion (230b) configured to move in response to movement of the second housing (220) and to be bent with a predetermined curvature radius,
wherein the flexible display (230) comprises:
a display area (AA) in which a plurality of pixels are activated;
a first non-display area (NA11) extending from the display area (AA) in a first direction, the first direction being a direction in which the flexible display (230) moves when the electronic device (200) transitions from the slide-out state to the slide-in state; and
a second non-display area (NA12) extending from the first non-display area (NA11) in the first direction,
wherein the first non-display area (NA11) is an area in which a thin-film encapsulation layer (TFE) having a structure in which an organic layer (1252) is disposed between two inorganic layers (1251, 1253) is formed, and the second non-display area (NA12) is an area in which the thin-film encapsulation layer (TFE) having a structure in which the two inorganic layers (1251, 1253) are laminated is formed, and
wherein a position of the bending portion (230b) on the flexible display (230) changes according to a state transition of the electronic device (200), and the second non-display area (NA12) is positioned so as not to be included in the bending portion (230b) in any state of the electronic device (200).

2. The electronic device (200) of claim 1, wherein the thin-film encapsulation layer (TFE) comprises:
a first encapsulation area (TFE1) comprising a first encapsulation layer (1251) comprising an inorganic layer, a second encapsulation layer (1252) disposed on the first encapsulation layer (1251) and comprising an organic layer, and a third encapsulation layer (1253) disposed on the second encapsulation layer (1252) and comprising an inorganic layer; and
a second encapsulation area (TFE2) disposed around the first encapsulation area (TFE1), and comprising the first encapsulation layer (1251) and the third encapsulation layer (1253),
wherein the first encapsulation area (TFE1) is disposed to correspond to the display area (AA) and the first non-display area (NA11), and
wherein the second encapsulation area (TFE2) is disposed to correspond to the second non-display area (NA12).

3. The electronic device (200) of claim 1, further comprising:
one or more dams (1211, 1212) disposed in the second non-display area (NA12),
wherein the thin-film encapsulation layer (TFE) covers the one or more dams (1211, 1212).

4. The electronic device (200) of claim 3, wherein the one or more dams (1211, 1212) disposed in the second non-display area (NA12) comprise:
a first dam having a first width and a first height, and
a second dam having a second width and a second height, and disposed at a predetermined distance from the first dam.

5. The electronic device (200) of claim 4, wherein the one or more dams (1211, 1212) disposed in the second non-display area (NA12) further comprise: a third dam having a third width and a third height, and disposed at a predetermined distance from the second dam.

6. The electronic device (200) of claim 4, wherein the first width, the second width, and the third width are equal to each other, and
wherein the first height, and the second height are equal to each other.

7. The electronic device (200) of claim 4, wherein the first width, the second width, and the third width may be different from each other, and
wherein the first height, and the second height are different from each other.

8. The electronic device (200) of claim 4, wherein the first dam, and the second dam have identical cross-sectional shapes.

9. The electronic device (200) of claim 4, wherein cross-sectional shapes of the first dam, and the second dam have different cross-sectional shapes.

10. The electronic device (200) of claim 4, wherein a size of a cross-section of the first dam is different from a size of a cross-section of the second dam.

11. The electronic device (200) of claim 4, wherein each of the first dam and the second dam has a regular taper shape in which a width decreases from bottom to top.

12. The electronic device (200) of claim 4, wherein the flexible display (230) further comprises a third non-display area (NA3, NA4) extending in a second direction perpendicular to the first direction from the display area (AA), and
wherein the number of one or more dams disposed in the third non-display area is less than the number of the one or more dams (1211, 1212) disposed in the second non-display area (NA12).

13. The electronic device (200) of claim 3, further comprising:
a peel-off prevention dam (2010) disposed outside the one or more dams (1211, 1212) in the second non-display area (NA12) and covering an end of the thin-film encapsulation layer (TFE).

14. The electronic device (200) of claim 13, further comprising:
a crack prevention dam (2110) disposed outside the peel-off prevention dam (2010) in the second non-display area (NA12) and having a size smaller than that of the peel-off prevention dam (2010).

15. The electronic device (200) of claim 14, wherein an adhesive strength of a material included in the crack prevention dam (2110) is greater than an adhesive strength of a material included in the peel-off prevention dam (2010).
